Europäisches Patentamt

European Patent Office

Office européen des brevets

(11) Numéro de publication : **0 454 578 B1**

(12) **FASCICULE DE BREVET EUROPEEN**

(45) Date de publication du fascicule du brevet :
**13.07.94 Bulletin 94/28**

(51) Int. Cl.$^5$ : **G01R 31/02**

(21) Numéro de dépôt : **91401091.3**

(22) Date de dépôt : **24.04.91**

(54) **Procédé pour vérifier l'efficacité du blindage électromagnétique d'un cordon conducteur, et dispositif pour la mise en oeuvre du procédé.**

(30) Priorité : **27.04.90 FR 9005361**

(43) Date de publication de la demande :
**30.10.91 Bulletin 91/44**

(45) Mention de la délivrance du brevet :
**13.07.94 Bulletin 94/28**

(84) Etats contractants désignés :
**AT BE CH DE DK ES FR GB GR IT LI LU NL SE**

(56) Documents cités :
**DE-A- 1 590 766**
**FR-A- 2 170 830**
**IEEE 1985 INTERNATIONAL SYMPOSIUM ON ELECTROMAGNETIC COMPATIBILITY, Boston, MA,20 - 22 août 1985, SYMPOSIUM RECORD, pages 287-295; S. AHMAD et al.: "Shielding**
**and ageing effects with flexible coaxial cable"**
**TOUTE L'ELECTRONIQUE, mai 1980, no. 454, pages 63-67; "Etude des influencesextérieu-res sur les liaisons coaxiales"**

(73) Titulaire : **BULL S.A.**
**Tour BULL,**
**1, place Carpeaux**
**F-92800 Puteaux (FR)**

(72) Inventeur : **Guedon, Yves**
**8, Rue le Verger des Marottes**
**F-49220 Le Plessis Mace (FR)**
Inventeur : **Rattier, Paul**
**38, Rue Galles**
**F-49080 Bouchemaine (FR)**
Inventeur : **Demoulin, Bernard**
**16, Rue de la Gare**
**F-59282 Noyelles sur Selle (FR)**
Inventeur : **Robin, Serge**
**51, Domaine des Ecots**
**F-49070 St. Lambert la Potherie (FR)**
Inventeur : **Rochdi, Mohamed**
**119, rue Brûle Maison**
**F-59000 Lille (FR)**

(74) Mandataire : **Denis, Hervé et al**
**BULL S.A.**
**Tour BULL Cédex 74**
**PC/TB2803**
**F-92039 Paris La Défense (FR)**

## Description

L'invention est relative à un procédé pour vérifier l'efficacité du blindage électromagnétique d'un cordon conducteur blindé, et à un dispositif pour la mise en oeuvre du procédé.

Un cordon conducteur est un dispositif permettant de relier deux appareils électroniques entre eux. A cet effet, un cordon conducteur est composé d'un câble enfermant au moins un conducteur, et par deux connecteurs disposés un à chaque extrémité du câble, de façon à permettre la connexion entre le câble et les deux appareils. Dans de nombreuses applications, il ne faut pas que les signaux qui transitent sur le ou les conducteurs d'un cordon puissent être perturbés par des signaux extérieurs, et c'est pourquoi il est connu de réaliser un blindage électromagnétique des cordons en emprisonnant les fils conducteurs à l'intérieur d'une barrière métallique conductrice de l'électricité. A cet effet, chaque connecteur se présente sous la forme d'un boîtier métallique, et le ou les conducteurs du câble sont emprisonnés dans une tresse ou un maillage métallique qui réalise un conduit dans lequel passent le ou les conducteurs du cordon et leur gaine isolante. Afin que la continuité du blindage soit assurée entre le câble et les connecteurs, le blindage du câble est relié électriquement par soudure, ou bien par serrage, ou par tout autre moyen approprié au blindage des connecteurs.

Ainsi emprisonnés, les conducteurs du cordon ne doivent pas pouvoir subir de perturbations électromagnétiques dues à des signaux extérieurs. L'efficacité d'un blindage se reconnaît donc à son aptitude à éviter que des signaux qu'il reçoit aient une influence quelconque sur les signaux qui transitent à l'intérieur du cordon.

Cependant, il peut arriver dans certains cas que des défauts de contact apparaissent entre le blindage de l'un et/ou de l'autre des connecteurs et le blindage du câble, de sorte que le comportement global du blindage du cordon peut devenir insatisfaisant. Il en résulte que les conducteurs enfermés dans le câble peuvent subir des perturbations électromagnétiques de l'extérieur, ou bien, à l'inverse, que le cordon soit la cause de perturbations électromagnétiques vis-à-vis de son environnement extérieur.

Ces phénomènes sont bien connus, et on connaît déjà des procédés pour tester la qualité ou l'efficacité du blindage électromagnétique de cordons. Un procédé connu consiste à injecter un courant à fréquence variable et évoluant dans le temps dans le blindage et à mesurer une tension parasite qui apparaît sur l'un des conducteurs du câble, en venant se connecter à la broche correspondante de l'un des connecteurs. A cet effet, le cordon est installé dans un conduit métallique, de façon à ce qu'une ligne de propagation coaxiale soit réalisée. Un générateur est connecté à une extrémité de cette ligne, et une charge est connectée à l'autre extrémité entre le conduit métallique et le blindage. Ce montage permet de produire dans le blindage un courant qui peut être assimilé à un courant perturbateur lorsque le générateur fonctionne. Un récepteur sensible, connecté à l'extrémité du cordon sur l'un des conducteurs du câble, permet de mesurer la tension parasite qui résulte du passage du courant dans le blindage. L'amplitude de cette tension rapportée à l'amplitude du courant perturbateur permet d'apprécier l'efficacité du blindage. Cependant, l'efficacité évolue en fonction de la fréquence du courant perturbateur et il est donc nécessaire de mener le test sur une large gamme de fréquences qui va généralement de quelques kilohertz à une dizaine de mégahertz.

Cependant, le procédé de mesure ne permet pas de répondre aux impératifs exigés par les circonstances industrielles.

En effet, même si le générateur est piloté automatiquement, l'exploration du spectre n'est pas instantanée et demande un temps non négligeable, qui peut aller jusqu'à quelques minutes, ce qui ne correspond absolument pas aux conditions de rapidité exigées dans le domaine industriel ;

- d'autre part, le procédé utilisé permet de réaliser une mesure précise des tensions parasites qui apparaissent sur l'un des conducteurs, et permet de bien visualiser comment évolue la tension parasite en fonction de la fréquence. Cependant, il ne suffit pas à établir facilement si le blindage est mauvais, douteux ou bon. En effet, la mesure permet juste d'établir une variation absolue de l'efficacité en fonction de la fréquence, mais elle ne permet pas pour autant d'effectuer rapidement des mesures comparatives et en conséquence d'établir l'efficacité réelle du blindage ;

- enfin, ce procédé de mesure nécessite que le cordon à tester soit installé dans un tube métallique, pour réaliser la ligne de propagation coaxiale, ce qui est très peu pratique dans la réalité, surtout pour des tests de grandes séries. En effet, la mise en place du cordon dans un tube métallique nécessite une manipulation assez lourde ; par ailleurs, cette mise en place, si elle demeure concevable pour des cordons de faible longueur, n'est pas applicable à des cordons de longueur plus importante ; enfin, le test sur l'efficacité du blindage électromagnétique d'un cordon n'est généralement pas réalisé dès que le cordon sort de sa chaîne de fabrication, alors que très souvent, dès la sortie de chaîne, le cordon est enroulé sur lui-même et se présente en bobine. En conséquence, la mise en place du cordon dans un tube métallique nécessiterait le déroulage de la bobine, ou bien encore imposerait que le test soit réalisé immédiatement après la sortie de la chaîne de fabrication, avant que le cordon soit embobiné.

Une variante de ce procédé antérieur a été décrite dans le document FR-A-2 170 830. Selon cette variante, le signal perturbateur est une tension au lieu d'un courant, mais cette variante présente les mêmes inconvénients, sauf celui relatif à la mise en place du cordon dans un tube métallique.

La présente invention a pour but de remédier à ces inconvénients et a tout particulièrement pour objet un procédé qui permet de vérifier d'une façon fiable l'efficacité du blindage électromagnétique d'un cordon du genre précité, d'une façon rapide et qui soit applicable à des cordons présentés en bobine.

L'invention a pour objet un procédé pour vérifier l'efficacité du blindage électromagnétique d'un cordon, le procédé ayant les caractéristiques définies dans la revendication 1.

L'invention met en oeuvre un principe relativement simple qui n'avait pas été envisagé jusque là. Plutôt que d'effectuer une étude de la réponse fréquentielle d'un cordon soumis à un signal perturbateur évoluant dans le temps, l'invention met en oeuvre un principe selon lequel certains signaux transitoires, s'ils sont déterminés, permettent de mettre en évidence les défauts de blindage électromagnétique.

Par ailleurs, le signal perturbateur est injecté dans le blindage du cordon, c'est-à-dire qu'il passe à la fois dans le blindage des connecteurs et dans le blindage du câble, de sorte que le signal résultant est directement fonction du comportement global du blindage du cordon. Ceci est particulièrement avantageux, puisqu'il n'est pas nécessaire de tester par exemple dans une première étape le blindage du câble, puis de faire une seconde mesure pour tester le blindage complet du cordon.

Cependant, comme il sera expliqué plus en détail ultérieurement, des cordons différents, soumis à un même signal perturbateur entraînent l'apparition de signaux résultants différents. En effet, la longueur du cordon, ou le nombre des conducteurs internes, ou l'existence de fils de masse reliés au blindage des connecteurs sont autant d'éléments qui interviennent sur le signal résultant. En outre, le conditionnement du cordon influe également sur le signal résultant : le signal résultant apparaissant sur un conducteur d'un cordon déroulé sera différent du signal résultant apparaissant sur le même conducteur d'un cordon identique présenté en bobine.

C'est pourquoi, selon une autre caractéristique du procédé de l'invention, les paramètres nécessaires à l'obtention du signal perturbateur sont déterminés en fonction du cordon testé et de son conditionnement. Ainsi, il est possible d'obtenir le signal perturbateur le plus approprié pour obtenir une réponse fiable et exploitable.

En conséquence, un dispositif pour la mise en oeuvre du procédé de l'invention comporte des moyens pour piloter le signal perturbateur, et être utilisable avec tous types de cordons rencontrés.

D'autres principes, caractéristiques et avantages de l'invention apparaîtront avec la description ci-après faite en regard des figures annexées sur lesquelles :

- la figure 1 représente un cordon conducteur ;
- la figure 2 illustre le principe physique du procédé conforme à l'invention ;
- la figure 3 montre un type de signal transitoire qu'il est possible d'utiliser pour mettre en évidence le défaut de blindage ;
- les figures 4 et 5 montrent, en fonction du signal injecté dans le blindage, deux réponses qu'il est possible d'obtenir au niveau de la mesure sur un cordon dont le blindage est correct ;
- les figures 6A, 7A, 8A montrent chacune un cordon présentant un type de défaut de blindage différent, et les figures 6B, 7B, 8B montrent, pour chacun des défauts respectifs, le signal mesuré en raison de l'existence de chaque défaut, en regard du signal qui aurait dû apparaître si le blindage de chaque cordon avait été conforme ;
- la figure 9 montre le schéma de principe d'un dispositif utilisable pour l'ensemble du test de cordons non conditionnés en bobine, ou pour une phase préparatoire au test de cordons conditionnés en bobine ;
- la figure 10 montre le schéma de principe d'un dispositif pour le test de cordons conditionnés en bobine ;
- les figures 11 et 12 illustrent des signaux susceptibles de circuler respectivement dans les montages des figures 9 et 10 ;
- la figure 13 illustre un schéma de principe complet d'un dispositif pour le test de cordons conditionnés en bobine.

Le procédé de l'invention permet d'exécuter rapidement un test de l'efficacité du blindage électromagnétique d'un cordon conducteur en utilisant des signaux perturbateurs à caractère impulsionnel. Le principe mis en oeuvre est extrêmement simple, puisqu'il suffit de confronter la signature du signal résultant sur l'un des conducteurs du cordon à une signature de référence pour juger les critères d'efficacité du blindage.

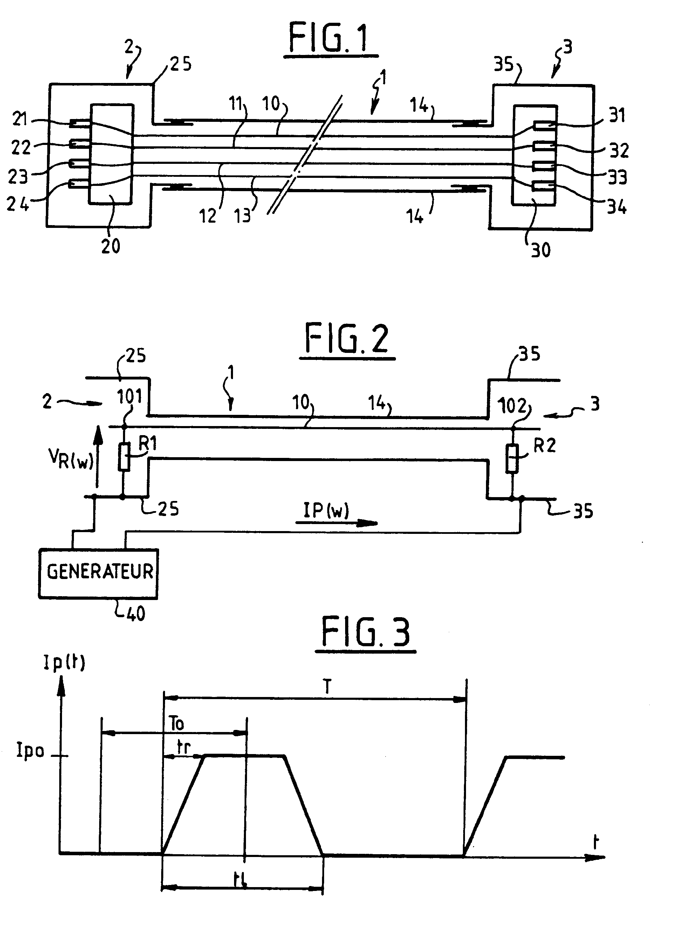

Sur la figure 1, on a représenté, pour mémoire, le schéma de principe connu en soi d'un cordon conducteur.

Un cordon est constitué par un câble (1) terminé à chacune de ses extrémités par un connecteur (2, 3). Le câble (1) enferme au moins un fil conducteur (10, 11, 12, 13), chaque fil étant relié à une fiche correspondante, mâle ou femelle, dans chaque connecteur (2, 3). A cet effet, chaque connecteur enferme un bloc (20, 30) supportant lesdites fiches (21, 22, 23, 24 ; 31, 32, 33, 34), afin de permettre la liaison de deux dispositifs électroniques, non représentés sur la figure, par l'intermédiaire du cordon.

Dans l'exemple illustré par la figure 1, le connecteur (2) est un connecteur mâle, alors que le connecteur (3) est un connecteur femelle. Il est bien entendu que cette disposition n'a rien de limitative et que toutes les combinaisons sont possibles (mâle/mâle, mâle/femelle, femelle/femelle). De même, le câble représenté sur cette figure ne comporte que quatre conducteurs (10, 11, 12, 13) et les conducteurs ont été représentés avec un nombre correspondant de broches ou de fiches. Ceci n'a absolument rien de limitatif, car il est connu que les connecteurs comportent généralement un nombre de broches ou de fiches nettement supérieur à ce qui a été représenté, de même que les câbles comportent généralement un nombre nettement supérieur de fils conducteurs.

En outre, il n'est pas nécessaire qu'un connecteur relié à un câble ait un nombre de broches ou de fiches égal au nombre de conducteurs du câble. Il est en effet courant que la totalité des broches ou des fiches ne soit pas connectée, car le câble comporte un nombre inférieur de conducteurs.

Le blindage du cordon est assuré d'une part par un blindage de chaque connecteur et d'autre part par un blindage du câble.

Le blindage de chaque connecteur est constitué par une coque métallique (25, 35) entourant les broches ou les fiches, et le blindage du câble (1) est par exemple réalisé à l'aide d'une tresse métallique (14) entourant les conducteurs (10, 11, 12, 13), eux-mêmes isolés les uns des autres à l'aide d'une gaine isolante non représentée sur cette figure, ceci étant connu en soi. Pour que le blindage du cordon soit le plus parfait possible, une continuité électrique est assurée entre le blindage du câble et le blindage des connecteurs, par exemple en soudant la tresse métallique (14) au blindage (25, 35) de chaque connecteur, ou bien encore à l'aide de colliers de serrage.

La figure 2 illustre le principe physique du test, néanmoins sans montrer tous les éléments ou dispositifs nécessaires à sa réalisation.

Sur cette figure, on a représenté de façon schématique le blindage du cordon (25, 14, 35) et un conducteur (10), sur lequel la mesure du signal résultant va être effectuée. Une extrémité (101) du conducteur (10) est reliée au blindage (25) du connecteur (2) correspondant par l'intermédiaire d'une résistance (R1), et la seconde extrémité (102) du conducteur (10) est reliée au blindage (35) du connecteur (3) correspondant par l'intermédiaire d'une résistance (R2). Par ailleurs, un générateur (40), possédant une borne d'entrée et une borne de sortie est relié par l'intermédiaire de sa borne de sortie au blindage (25) de l'un des connecteurs (2), et par sa borne d'entrée au blindage (35) du second connecteur (3). Ce générateur (40) permet qu'un courant $I_p(w)$ puisse être injecté dans le cordon par l'intermédiaire des blindages des connecteurs.

On démontre facilement, avec le montage illustré, que la tension résultante $V_r(w)$ qui apparaît entre le fil conducteur (10) et le blindage de l'un des connecteurs est reliée au courant perturbateur $I_p(w)$, à condition que les résistances (R1) et (R2) aient une valeur identique, par la relation :

$$V_r(w) = \tfrac{1}{2} Z_t(w) I_p(w) \quad (1)$$

où $I_p(w)$ représente, comme indiqué ci-avant le courant perturbateur injecté dans le blindage du cordon, et $Z_t(w)$ représente l'impédance de transfert du cordon.

Pour que la relation (1) soit valable, il faut non seulement que les résistances (R1) et (R2) soient identiques, mais encore que la longueur d'onde associée à la pulsation (w) soit supérieure à la longueur totale du cordon.

L'impédance de transfert ($Z_t$) est une valeur représentative de l'efficacité du blindage du cordon. De la même manière que la relation (1) exposée auparavant est connue en soi, il est connu que pour les cordons usuels, l'impédance de transfert ($Z_t$) s'exprime de la façon suivante :

$$Z_t(w) = R_o + j L_t w \quad (2)$$

Dans cette relation (2), $R_o$ traduit l'ensemble des résistances qui existent entre les deux connecteurs : ainsi, $R_o$ est fonction de la résistance du blindage de chaque connecteur, du blindage du câble, de la résistance de contact entre le blindage du câble et le blindage de chaque connecteur, de la valeur des résistances (R1) et (R2), et d'une façon générale, elle est fonction de toutes les résistances apparaissant dans le câble.

$L_t$, qui s'apparente à une inductance, traduit les couplages d'origine magnétique qui peuvent exister à l'intérieur du câble, et entraîner des perturbations sur le conducteur (10), lorsque des ouvertures sont présentes sur la surface des blindages, ou bien encore lorsqu'une partie du courant perturbateur transite par l'intermédiaire des fils de masse internes au cordon. En effet, dans certains cas, il existe des fils de masse internes au cordon qui relient les blindages des connecteurs entre eux.

L'invention met à profit les relations qui existent entre les courants qui peuvent circuler dans le cordon, en étant injectés à partir du blindage des connecteurs, et la tension résultante qui peut apparaître au niveau de l'un des conducteurs dont chacune des extrémités est connectée sur une charge placée entre ledit conducteur et le blindage du connecteur correspondant.

L'invention a donc consisté à déterminer quel type de courant est le plus approprié pour mettre en évidence les défauts de blindage électromagnétique, et à trouver une solution qui permette de produire ce courant quel que soit le conditionnemment du cordon.

La figure 3 montre la forme préférée du signal perturbateur qui permet de déterminer de façon optimale la qualité du blindage électromagnétique du cordon.

Sur la figure 3, on a représenté, en fonction du temps (t) des impulsions de courant $I_p$ (t) qui s'apparentent à des trapèzes de période T, de largeur $t_i$, et de front de transition $t_r$. Le courant $I_p$ (t) passe par un maximun $I_{po}$. Un tel type de courant perturbateur peut provenir d'un générateur d'impulsions, connu en soi, qui permet de fournir des signaux récurrents tels qu'ils sont représentés.

Le choix de la période T et de la largeur $t_i$ des impulsions n'est pas fondamental. Cependant, il est préférable que T soit au moins supérieur à une milliseconde et que $t_i$ soit de l'ordre de dix microsecondes au moins.

Par contre, ainsi qu'il sera montré ultérieurement, la durée de la transition $t_r$ est fondamentale, car c'est le réglage de cette largeur qui permettra de faire apparaître ou non les défauts de couplage électromagnétique qui peuvent survenir dans le cordon.

Sur cette figure 3, on a également représenté une séquence de largeur $T_o$ encadrant une transition montante du courant. Ainsi, $T_o$ débute lorsque le courant est encore à sa valeur minimum, et s'achève après qu'il ait atteint sa valeur maximum $I_{po}$.

Dans un mode de réalisation préféré, c'est pendant ces périodes $T_o$ que la détermination de la qualité du blindage électromagnétique est effectuée.

Bien entendu, il est possible, de travailler sur une séquence comparable qui débute lorsque le courant $I_{po}$ est à sa valeur maximum, et se termine lorsque le courant $I_{po}$ atteint sa valeur minimum, la période de mesure entourant un front descendant.

Dans la suite de la description, on décrira la mise en oeuvre du procédé, lorsque les mesures sont effectuées sur les fronts montant du courant $I_{po}$, c'est-à-dire lorsque la séquence de mesure débute alors que le courant est à sa valeur minimum, et s'achève lorsqu'il a atteint sa valeur maximum $I_{po}$. En effet, la détermination des phénomènes qui se produisent pendant les transitions descendantes du courant est à la portée de l'homme du métier, et se déduit sans difficulté de la présente description.

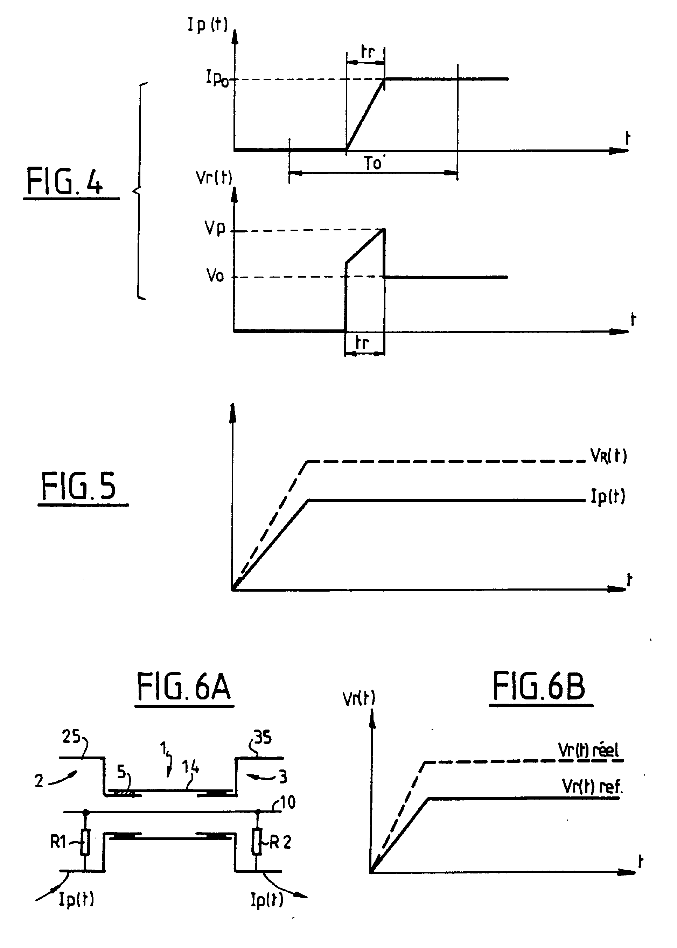

Sur la figure 4, on a représenté deux graphes représentant respectivement, dans le domaine temporel, l'évolution du courant $I_p$(t) (partie supérieure de la figure) et l'évolution correspondante de la tension résultante $V_r$ (t) apparaissant au niveau du fil conducteur, pour un câble conforme (partie inférieure de la figure).

On constate, à l'aide de cette figure 4, que lorsque le courant $I_p$ (t) est nul, alors la tension $V_r$ (t) résultante est nulle. Ceci est conforme à la relation (1) qui a été présentée auparavant et qui montre la relation entre le courant et la tension résultante. Lorsque la transition s'amorce, il apparaît une brusque variation de la tension $V_r$ (t) due essentiellement aux phénomènes d'inductances survenant dans le cordon.

Ensuite, pendant toute la durée restante de la transition, la tension $V_r$ (t) continue à évoluer de façon linéaire, pour atteindre un maximum $V_p$ à l'issue de la transition, c'est-à-dire au moment où le courant $I_p$(t) atteint sa valeur maximum $I_{po}$. Ensuite, la tension $V_p$ (t) s'infléchit brusquement et passe d'une façon quasi instantanée de la valeur $V_p$ à une valeur $V_o$ de palier comprise entre $V_p$ et la valeur nulle.

En fait, la courbe $V_r$ (t) se déduit directement de l'application de la relation (1) sur un courant $I_p$ (t) ayant les caractéristiques présentées dans la partie supérieure de cette figure 4.

La courbe $V_r$ (t) est donc la signature d'un courant $I_p$ (t) évoluant comme représenté, et on constate que cette signature comporte deux éléments caractéristiques particulièrement importants, et ce sont ces éléments que l'invention exploite pour déterminer si le blindage est correct ou non.

Ces deux éléments sont respectivement le maximum de tension résultante $V_p$ qui apparaît lors de la transition de courant, et le palier d'amplitude $V_o$ qui demeure tant que le courant est à sa valeur maximum $I_{po}$.

Si l'impédance de transfert est conforme à la relation (2), alors il est possible, en développant la relation (1), de montrer que le maximum de tension parasite répond à la relation (3) suivante :

$$V_p = \tfrac{1}{2} (R_o + L_t/t_r)\, I_{po} \quad (3)$$

et que la valeur de la tension $V_o$ du palier répond à la relation (4) suivante :

$$V_o = \tfrac{1}{2} R_o\, I_{po} \quad (4)$$

On constate donc que la valeur de la tension du palier $V_o$ est directement fonction de la résistance de transfert et du courant maximum $I_{po}$, et que le maximum de tension parasite $V_p$ est fonction non seulement de la valeur de la résistance de transfert, mais encore de la valeur de l'inductance de transfert, et de la durée $t_r$ de la transition.

En conséquence, ces deux dernières relations contiennent toutes les informations traduisant le couplage électromagnétique à travers le cordon et donc des paramètres intéressants pour qualifier la qualité du blindage.

En effet, des cordons conformes, c'est-à-dire dont la qualité est bonne, et qui seraient d'un même type (même longueur, même nombre de conducteurs internes, même type de câble et de connecteurs), auraient une réponse temporelle à peu près identique. Par contre, si la qualité du blindage électromagnétique varie d'un câble du même type à l'autre, alors le signal résultant apparaissant au niveau de l'un des conducteurs devient différent d'un cordon à l'autre.

Dans un mode préféré de mise en oeuvre de l'invention, on détermine quel est le signal résultant apparaissant sur un cordon conforme, pour un courant $I_p$ (t) donné, ayant une transition $t_r$ de durée déterminée, et on détermine la conformité des autres cordons, en les soumettant au même courant $I_p$ (t) ,

ayant une même transition $t_r$, et on évalue la conformité en mesurant les différences qui existent entre le signal résultant de référence établi à partir du cordon conforme, et les signaux résultants mesurés sur chaque cordon testé.

Par ailleurs, de préférence également, les paramètres de réglage du signal perturbateur, et en particulier la durée de la transition $t_r$, injecté dans le blindage du cordon sont choisis de façon que les couplages magnétiques acceptables sur un cordon conforme n'apparaissent pas sur le signal de référence, ou tout au moins soient très atténués.

On y parvient différemment selon que le cordon à tester est présenté en bobine ou non.

L'intérêt à agir ainsi est expliqué ci-après.

La relation (3), présentée précédemment, et qui donne la valeur $V_p$ du maximum de tension apparaissant lors de la transition du courant, en fonction de la valeur maximum $I_{po}$ du courant, fait apparaître le rapport $L_t/t_r$, c'est-à-dire le rapport entre l'inductance de transfert et la durée de la transition.

L'inductance de transfert $L_t$ est directement fonction des caractéristiques du cordon à tester, alors que la durée de la transition $t_r$ peut être imposée par l'opérateur réalisant le test. On constate donc que, si on augmente infiniment la durée de la transition $t_r$, alors le rapport $L_t/t_r$ devient infiniment petit, de sorte que le maximum de tension parasite devient quasiment confondu avec la valeur du palier $V_o$ de tension lorsque le courant atteint la valeur $I_{po}$.

Sur un câble conforme, l'inductance de transfert $L_t$ du cordon est faible, de sorte que plus la durée de la transition est forte, moins l'influence de cette inductance peut être mise en évidence.

C'est ce qui est illustré avec la figure 5, sur laquelle on a représenté l'évolution des courbes $I_p(t)$ en trait gras et $V_r(t)$ en trait interrompu. Dans ce cas, où la durée $t_r$ de la transition est suffisamment grande, alors l'influence de l'inductance $L_t$ du cordon est négligeable, de sorte que la tension résultante apparaissant au niveau du conducteur sur lequel la mesure est effectuée est homothétique de la signature du courant $I_p(t)$ circulant dans le blindage. En effet, dans ce cas, et ceci se déduit de la relation (1) précédente, la valeur de la tension résultante $V_r(t)$ est donnée par la relation suivante :

$$V_r(t) = \tfrac{1}{2} R_o I_p(t) \quad (5)$$

Il n'apparaît donc plus de pic $V_p$ pendant la transition.

Sur la figure 6A, est représenté un cordon avec un câble (1) et deux connecteurs (2, 3) dans lequel il existe un défaut de contact, par exemple, entre le câble (1) et l'un des connecteurs (2). Ce défaut de contact a été schématisé par un élément référencé (5) sur la figure. Il peut par exemple s'agir d'un mauvais soudage, ou d'un mauvais serrage entre le blindage du câble (1) et le blindage du connecteur (2).

Dans ce cas, le défaut de contact entraîne une augmentation de la résistance de transfert du câble par rapport à sa valeur $R_o$ sur un cordon conforme.

Si le défaut de contact n'est pas franc, c'est-à-dire que la valeur de la résistance de transfert ne devient pas infinie, alors il en résulte une augmentation de la tension résultante apparaissant au niveau du conducteur (10) sur lequel est effectuée la mesure.

C'est ce qui a été illustré par la figure 6B, sur laquelle est représentée en trait continu la valeur de la tension ($V_r(t)$ réf) qui aurait dû apparaître si le cordon avait été conforme, et sur laquelle on a représenté en trait interrompu la valeur de la tension ($V_r(t)$ réelle) telle qu'elle serait mesurée au niveau du conducteur. Cette tension est homothétique de la tension ($V_r(t)$ réf), et supérieure en tous points à celle-ci.

Cependant, étant donné que du courant circule encore dans le blindage du cordon, il n'apparaît pas l'existence d'un couplage magnétique excessif entre les conducteurs du câble.

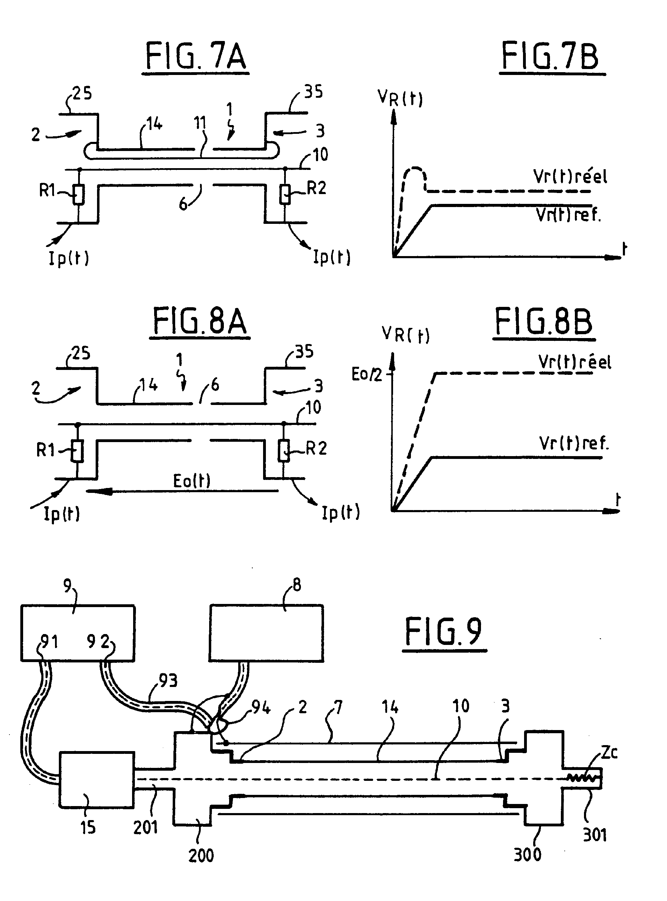

Les figures 7A, 7B et 8A, 8B correspondent respectivement à deux cas de figure dans lesquels le défaut de contact au niveau du blindage est franc. Ceci peut être dû à une rupture totale du blindage du câble, ou bien encore à une absence de connexion entre le câble et l'un et/ou l'autre des connecteurs. Sur les figures 7A et 8A, on a représenté, de façon schématique, un cordon dans lequel apparaît un tel défaut de contact. Le blindage du cordon avec son câble (1) et ses connecteurs (2, 3) présente une ouverture (6), de sorte que la résistance de contact entre le câble et les connecteurs est infinie.

Sur la figure 7A, on a envisagé une hypothèse dans laquelle il existe un fil conducteur interne (11) de masse qui relie les blindages des deux connecteurs (2, 3) entre eux. Dans ce cas, la valeur de la résistance de transfert est augmentée par rapport à la résistance de transfert $R_o$ d'un cordon conforme du même type, puisque le blindage n'intervient plus dans le transfert du courant. En effet, le blindage, dans un cordon conforme dans lequel il existe un fil de masse reliant les deux connecteurs, peut être considéré comme une résistance en parallèle sur ce fil de masse. En conséquence, la supression de cet élément en parallèle, qui intervenait dans la valeur de la résistance de transfert, entraîne une augmentation de la valeur globale de la résistance de transfert. La résistance de transfert est donc supérieure à la valeur qu'elle aurait dans un cordon conforme.

Par ailleurs, le courant perturbateur $I_p(t)$ est dérivé dans sa majeure partie, par le fil de masse, et il existe une infime partie du courant perturbateur qui passe par le conducteur (10) sur lequel la mesure est effectuée, mais cette valeur est très faible en raison de l'existence des résistances de couplage (R1) et (R2) qui ont été présentées en regard de la figure 2. Ainsi, étant donné que la majeure partie du courant perturbateur est dérivée par le fil de masse, il apparaît un fort couplage magnétique sur les autres fils conducteurs incorporés dans le câble, et en particulier sur le fil (10) sur lequel la mesure est effectuée, d'où il en résulte un accroissement important de l'inductance de transfert $L_t$. En conséquence, il apparaît un pic de tension significatif de l'existence du couplage magnétique, et une légère augmentation de l'amplitude du palier, après que le courant ait atteint sa valeur maximum, cette augmentation étant due à l'augmentation de la résistance $R_o$ intervenant dans l'impédance de transfert.

Tout ceci est illustré par la figure 7B, sur laquelle apparaît en trait plein la tension de référence qui devrait apparaître sur le cordon (10) d'un câble conforme, et en trait interrompu, la tension qui apparaît réellement.

Sur les figures 8A et 8B, on a illustré le cas où il existe une rupture (6) de contact franche, c'est-à-dire une coupure complète du blindage, sans qu'il existe un fil de masse reliant les deux connecteurs entre eux. Dans ce cas, le courant généré par la perturbation s'écoule directement, par l'intermédiaire des charges d'extrémité (R1) et (R2) dans le fil conducteur (10), et la tension apparaissant sur le fil conducteur (10) est la moitié de la tension fournie par le générateur entre les deux connecteurs, au cas où les résistances (R1) et (R2), reliant le fil conducteur (10) sur lequel est pratiquée la mesure à chaque connecteur, sont identiques. Or, dans ce cas, la résistance de transfert est surtout constituée par les résistances (R1) et (R2) en série, dont chacune est extrêmement supérieure à la résistance de transfert d'un câble conforme. En effet, pour un câble conforme, la résistance de transfert $R_o$ est de quelques milliohms par mètre (environ $10 \, \text{Om}\Omega/\text{m}$), alors que les résistances (R1) et (R2) valent chacune quelques dizaines d'ohms. En cas de coupure, il en résulte un accroissement considérable de la résistance de transfert, et en conséquence, une augmentation considérable de la valeur de la tension mesurée sur le conducteur (10).

Ainsi, il apparaît de ce qui précède que la calibration de la durée $t_r$ du front de montée du courant, ainsi que la comparaison de la signature $V_r(t)$ à une référence permet d'apprécier la qualité du blindage d'un cordon, et de classer ses performances en mauvais, douteux ou bon. Le cordon est mauvais lorsque la rupture est franche et lorsqu'il apparaît en conséquence soit une valeur de tension excessive, soit un pic significatif d'un couplage magnétique et une augmentation en conséquence du palier de tension par rapport à la référence ; le blindage est douteux lorsqu'il apparaît une augmentation notable, sans cependant être excessive du palier de tension : dans ce cas, il existe le risque d'une augmentation de la rupture qui ferait que le câble deviendrait mauvais ; le câble est bon lorsque la valeur mesurée correspond à peu près à la valeur de référence.

Cependant, le calibrage de la durée de la transition n'est pas toujours évident à réaliser et dépend essentiellement de la façon dont le cordon est conditionné.

L'invention propose en outre des moyens pour permettre un calibrage de la durée de la transition qui puisse être effectué de façon simple quel que soit le conditionnement du cordon.

La mise en oeuvre du procédé de l'invention, pour déterminer la qualité du blindage électromagnétique d'un cordon nécessite, quel que soit le mode de conditionnement de celui-ci, la réalisation de deux phases successives.

Une première phase, appelée phase préparatoire, a pour but de déterminer les paramètres nécessaires à l'obtention du courant perturbateur, en tenant compte des couplages électromagnétiques qui peuvent apparaître sur un câble conforme, et ce afin de rechercher la signature de référence, c'est-à-dire la tension qui doit apparaître sur le conducteur sur lequel est effectuée la mesure si le cordon testé est conforme.

La recherche de la signature de référence, pour un type de cordon donné, consiste en fait à établir une signature moyenne obtenue à partir d'essais pratiqués sur un prélèvement de cordons pouvant appartenir à plusieurs lots de fabrication. En effet, il apparaît qu'il peut exister, pour un même type de cordon, une certaine dispersion dans la valeur de la résistance de transfert $R_o$ des cordons. En fait, dans la pratique, la signature de référence sera établie à partir d'essais sur une dizaine de cordons, ce qui semble suffire.

La recherche et la mémorisation de la signature de référence peuvent être effectuées à l'aide d'un dispositif mettant en oeuvre, par exemple, un logiciel approprié. Ainsi, les mesures peuvent être effectuées à l'aide d'un oscilloscope numérique qui permet de dialoguer avec un calculateur et d'effectuer des traitements numériques sur les réponses des cordons testés, ou bien encore sur les réponses des cordons servant d'échantillons lors de la phase préparatoire.

Ainsi, l'amplitude maximum de tension qui est susceptible d'apparaître pendant la transition du courant peut être estimée à l'aide d'une détection d'amplitude crête, et le palier de tension qui s'établit lorsque le courant a atteint sa valeur maximum peut être effectué à l'aide d'un calcul de surface de signal.

La mise en oeuvre de ces principes est à la portée de l'homme du métier sans qu'il soit nécessaire de détailler plus la description sur ce point.

La deuxième phase de la mise en oeuvre du procédé conforme à l'invention consiste en la détermination proprement dite de la qualité du blindage électromagnétique des cordons testés. Cette phase consiste donc à relever, par exemple, à l'aide d'un oscilloscope numérique, la signature réelle des cordons, et à comparer cette signature réelle à la signature de référence calculée lors de la phase préparatoire. Bien entendu, la signature de référence n'est pas la même pour tous les types de cordons, et le logiciel ou d'une façon générale les moyens de traitement mis en oeuvre doivent permettre la distinction entre les différents types de cordons.

C'est pourquoi, la phase préparatoire ne consisterait pas simplement à déterminer une signature de référence, mais une bibliothèque de signatures de référence, chaque signature étant associée à un type de cordon donné, ce qui impliquerait que lors de la détermination de la qualité d'un cordon testé, l'opérateur indique au système de quel type de cordon il s'agit, pour que la détermination puisse se faire de façon automatique.

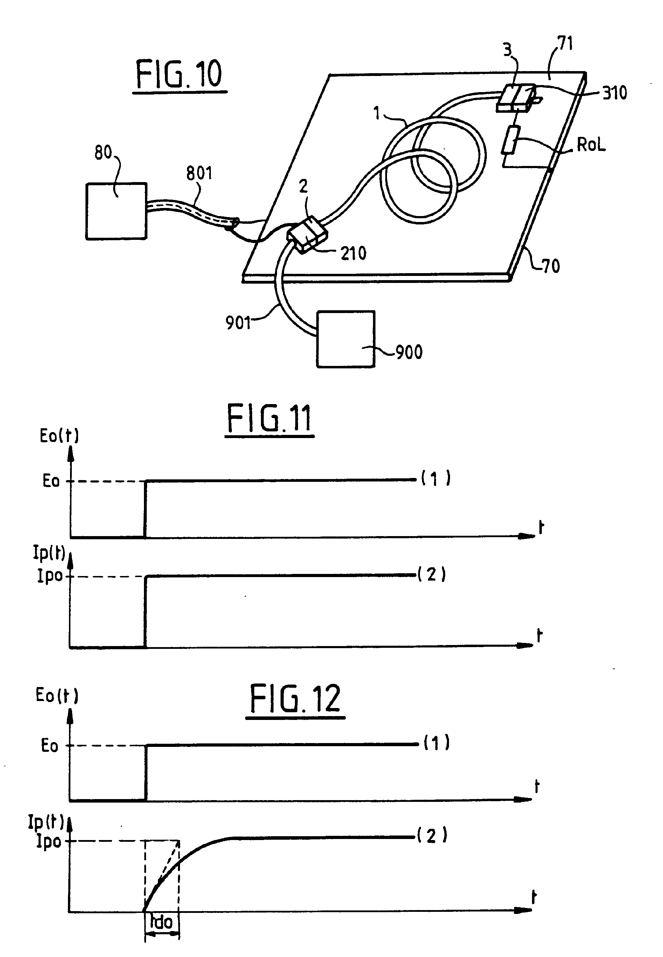

La figure 9 est un schéma de principe d'un montage permettant d'effectuer les phases préparatoires et les phases de mesure sur des cordons qui ne seraient pas conditionnés en bobine. Ce montage peut également être utilisé pour une partie de la phase préparatoire relative à des cordons qui seraient conditionnés en bobine.

Sur la figure 9, le cordon, constitué par le câble (1) et les connecteurs d'extrémité (2, 3), est installé dans un tube métallique (7). Au lieu d'un tube métallique, et ce sera le cas lorsque ce montage sera utilisé pour la phase préparatoire relative aux cordons conditionnés en bobine, on peut utiliser une enveloppe métallique souple. Un générateur d'impulsions (8) est connecté entre le blindage de l'un des connecteurs (2) et la structure coaxiale constituée par le tube métallique (7) ou l'enveloppe métallique. Une résistance de charge $R_l$ est interconnectée entre l'autre connecteur (3) et le tube (7) ou l'enveloppe métallique. La présence de la résistance de charge $R_l$ permet de transformer une tension produite par le générateur d'impulsions en courant circulant dans le blindage et dans l'enveloppe métallique, et à cet effet, la valeur de la résistance $R_l$ est choisie de façon que sa valeur soit proche de celle de l'impédance caractéristique de la structure coaxiale comprenant le blindage et le tube (7). Afin d'éviter des perturbations électromagnétiques pendant les phases utilisant ce montage, le blindage de chaque connecteur est relié à un boîtier interface étanche aux champs électromagnétiques. Ainsi, le blindage (25) du premier connecteur (2) est relié au blindage d'un premier boîtier (200), et le blindage (35) du second connecteur (3) est relié au blindage d'un second boîtier (300). Plus précisément, le générateur d'impulsions (8) est connecté entre le blindage du premier boîtier (200) et le tube ou l'enveloppe métallique coaxiale (7). La résistance de charge $R_l$ est reliée entre l'extrémité de la liaison métallique la plus proche du second connecteur (3) et le blindage du boîtier (300) associé à ce second connecteur (3).

En outre, le boîtier interface (200) associé au premier connecteur (2) et au générateur d'impulsions (8) assure la liaison entre le conducteur (10), sur lequel est effectuée la mesure, et la chaîne de mesure constituée dans l'exemple par un oscilloscope numérique (9) et par un amplificateur de tension (15). Le rôle de cet amplificateur de tension est d'élever l'amplitude des tensions parasites recueillies sur le câble lorsque leur niveau de tension est inférieur à une dizaine de microvolts. Dans un mode de réalisation, l'amplificateur de tension est un amplificateur large bande, d'impédance d'entrée égale à 50 ohms, et il est relié au boîtier interface (200) correspondant par l'intermédiaire d'un connecteur coaxial (201) au standard 50 ohms.

L'autre boîtier (300), dont le blindage est relié à la résistance de charge $R_l$ assure l'interface entre le connecteur (3) auquel il est relié et une impédance de charge $Z_c$. Une face de ce boîtier (300) reçoit le blindage (35) du connecteur (3) correspondant du cordon, et l'autre face du boîtier reçoit, dans l'exemple, un connecteur coaxial (301) au standard 50 ohms. L'impédance de charge $Z_c$, coaxiale, est reliée à la masse de ce connecteur coaxial (301) d'une part, et d'autre part par l'intermédiaire de ce boîtier, l'impédance $Z_c$ est reliée à l'extrémité correspondante du conducteur (10) sur lequel est effectuée la mesure. Ainsi, l'impédance de charge $Z_c$ se trouve reliée entre le conducteur (10) et le blindage (35) du connecteur correspondant.

L'impédance $Z_c$ est choisie de façon que sa valeur soit identique à l'impédance d'entrée de la chaîne de mesure, c'est-à-dire dans l'exemple illustré par cette figure, à l'impédance d'entrée de l'amplificateur ( 15 ) auquel une entrée (91) de l'oscilloscope numérique (9) est relié. Ainsi, l'impédance $Z_c$ joue le rôle de la résistance R2 des figures 2, 6A, 7A, 8A, et l'impédance d'entrée de la chaîne de mesure joue le rôle de la résistance R1 de ces mêmes figures. Une seconde entrée (92) de l'oscilloscope numérique reçoit un signal image du courant perturbateur injecté dans le blindage, par l'intermédiaire d'un cordon de liaison (93) relié d'une part à cette entrée (92), et d'autre part à un capteur (94) du courant circulant dans le blindage. Dans un mode de réalisation, le capteur (94) est un transformateur de courant large bande qui mesure le courant perturbateur par conversion courant-tension.

Comme il a été exposé auparavant, un tel montage peut être utilisé pour la détermination de la qualité du blindage électromagnétique de cordons de faible longueur.

Dans ce cas, la phase préparatoire consiste à effectuer des essais préliminaires pour déterminer, pour un type donné de cordon, quelle est la durée $t_r$ du front de montée qui permet de ne pas faire apparaître le pic de tension $V_p$ dû au couplage électromagnétique acceptable dans un câble conforme. En effet, tant que la durée du front de montée est inférieure à une valeur donnée, on obtient une réponse semblable à celle qui a été illustrée sur la figure 4.

Le but de cet essai est donc d'obtenir une tension de référence, au niveau du conducteur (10) qui soit semblable à celle qui a été présentée sur la figure (5).

En fait, le générateur d'impulsions permet d'obtenir des impulsions de tension de front de montée variable et de largeur variable. C'est la présence de la résistance de charge $R_l$ qui permet de transformer ces impulsions de tension en impulsions de courant circulant dans le blindage et dans la liaison coaxiale, comme expliqué précédemment.

Lorsque le temps de montée $t_r$ optimal a été déterminé, la signature de référence correspondante est mémorisée, et il est alors possible de procéder au test sur une série de cordons.

Dans ce cas, le test proprement dit consiste à utiliser le même montage que celui de la figure 9 et, pour un type de cordon donné, à générer les mêmes impulsions que celles qui ont donné naissance à la signature de référence mémorisée, afin d'obtenir une réponse sur le conducteur connecté d'une part à l'amplificateur de tension (15) et d'autre part à l'impédance de charge $Z_c$.

Si le cordon est conforme, alors la tension mesurée sur le conducteur sera très proche ou équivalente à la tension de référence.

Si le cordon n'est pas conforme, et selon la nature du défaut, la mesure fera apparaître entre la tension mesurée et la tension de référence, l'une ou l'autre des différences visualisées sur les figures 6B, 7B et 8B.

On conçoit cependant que l'utilisation d'un montage conforme à la figure 9 se prête difficilement au test de grandes séries de cordons, car il nécessite que chaque cordon soit introduit préalablement dans un tube ou dans une enveloppe métallique, ce qui nécessite des manipulations relativement longues et fastidieuses. En outre, elle ne se prête absolument pas aux tests de cordons conditionnés en bobine, puisqu'il faudrait dérouler chaque cordon à tester pour le placer dans le tube ou l'enveloppe métallique.

C'est pourquoi, l'invention propose également une variante permettant le test de cordons conditionnés en bobine, dont le schéma de principe apparaît sur la figure 10.

Le dispositif utilisé comporte un plan métallique (70) recouvert d'un écran isolant (71). Au lieu d'un plan métallique (70), on peut utiliser un grillage, ou tout autre dispositif conducteur équivalent, et au lieu d'un écran isolant (71), on peut utiliser tout autre dispositif permettant d'isoler le blindage du cordon du dispositif conducteur, par exemple des cales isolantes. Le cordon (1, 2, 3) configuré en bobine est posé sur l'écran isolant (71) recouvrant le plan métallique. Une résistance de charge $(R_ol)$ est reliée entre le plan métallique (70) et le blindage de l'un des connecteurs (3), par exemple par l'intermédiaire d'un boîtier interface (310). Ce boîtier interface (310) assure également la liaison entre le conducteur du cordon sur lequel est effectuée la mesure et le blindage du cordon, par l'intermédiaire d'une impédance de charge non représentée, mais équivalent à la résistance (R2) ou à l'impédance $(Z_c)$ précédemment décrites.

L'autre connecteur (2) est relié à un autre boîtier interface (210) qui permet de connecter le conducteur (10) sur lequel est effectuée la mesure au dispositif de mesure (900), par exemple par l'intermédiaire d'un câble coaxial (901). Le conducteur intérieur du câble coaxial est relié au conducteur (10) du cordon sur lequel est effectuée la mesure, et le blindage du câble coaxial est relié au blindage du boîtier interface (210). Sur la figure 2, illustrée précédemment, il apparaît qu'il faut que les deux extrémités du conducteur (10) sur lequel est effectuée la mesure soient reliées au blindage du cordon par l'intermédiaire de deux résistances ou impédances (R1, R2) identiques. Sur la figure 10, ces résistances n'apparaissent pas, mais l'une est connectée entre ledit conducteur et le blindage du connecteur (3) opposé à celui (2) relié à l'appareil de mesure (900). Afin, que les conditions de la figure 2 soient remplies, c'est l'impédance d'entrée de l'appareil de mesure (900) qui assure le rôle d'une première impédance (R1), et la seconde impédance (R2) est choisie de façon à être égale à l'impédance d'entrée de la chaîne de mesure.

Par ailleurs, le dispositif de la figure 10 comporte un générateur (80) dont la sortie est reliée à une liaison coaxiale (801). Le potentiel du générateur (80) est transmis au plan métallique (70) ou au dispositif conducteur par l'intermédiaire du conducteur intérieur de la liaison coaxiale (801), et la masse du générateur est connectée au blindage du connecteur (2) du cordon, par l'intermédiaire du boîtier interface (210). En conséquence, l'ensemble constitué par la bobine (1, 2, 3) et le plan métallique (70) recouvert par son écran isolant (71) joue le même rôle que la ligne coaxiale générant la perturbation illustrée sur la figure 9.

Par conséquent, un courant perturbateur peut circuler dans le blindage du cordon et des connecteurs.

Cependant, lorsque ce dispositif est soumis à des signaux impulsionnels, son comportement est totalement différent de celui d'une ligne coaxiale.

En effet, dans une ligne coaxiale adaptée, le courant $I_p$ (t) fourni par le générateur est homothétique de la tension fournie par celui-ci. En conséquence, si par exemple la tension fournie est un échelon d'amplitude $E_o$ et de front de montée quasi nul, alors le courant perturbateur $I_p$ (t) délivré par le générateur est un échelon d'amplitude $I_{po}$ et de front de montée correspondant au front de montée de la tension.

Par contre, le cordon, lorsqu'il est conditionné en bobine, présente une inductance $L_o$ non négligeable qui influe sur la forme du courant perturbateur délivré par le générateur. En effet, dans ce cas, si la tension délivrée par le générateur est encore un échelon

d'amplitude $E_o$ et de front de montée quasi nul, alors le courant croît de façon exponentielle vers un palier $I_{po}$, et une expression possible du courant en fonction du temps est donnée par la relation suivante :

$$I_p (t) = I_{po} (1 - e^{- t/to}) \quad (6)$$

dans laquelle $t_o$ est la constante de temps du circuit constitué par l'inductance $L_o$ du cordon et la résistance de charge $R_o l$ d'extrémité, et peut s'exprimer par la relation suivante :

$$t_o = L_o/R_o l \quad (7)$$

Par ailleurs, le palier $I_{po}$ vers lequel tend le courant $I_p$ (t) est fonction de la tension délivrée par le générateur et de la résistance de charge $R_o l$. Le palier $I_{po}$ peut s'exprimer de la façon suivante :

$$I_{po} = E_o /R_o l \quad (8)$$

Ce qui vient d'être décrit est représenté sur les figures 11 et 12 qui comprennent chacune deux courbes.

La courbe (1) de la figure 11 représente la tension $E_o(t)$ en fonction du temps. Il s'agit d'un échelon d'amplitude maximum $E_o$ et de front de montée nul.

La courbe (2) de cette figure 11 représente l'évolution correspondante du courant $I_p$ (t). On constate que le courant $I_p$ (t) est homothétique de la tension $E_o(t)$ fournie par le générateur, et en conséquence c'est un échelon d'amplitude $I_{po}$, et de front de montée nul.

Sur la figure 12, on a représenté également deux courbes. La courbe (1), identique à la courbe (1) de la figure 11, représente l'évolution de la tension $E_o$ (t) fournie par le générateur, et la courbe (2) illustre l'évolution correspondante du courant perturbateur $I_p$ (t).

On constate, grâce aux deux courbes de la figure 12, la montée exponentielle du courant perturbateur $I_p$ (t), à partir du moment où le générateur délivre son échelon de tension.

En conséquence, contrairement aux dispositifs coaxiaux, ce n'est pas seulement le générateur qui impose le front de montée du courant, mais c'est en plus l'existence de l'inductance $L_o$ et de la résistance de charge $R_o l$. En conséquence, un tel montage élimine toute la souplesse du réglage du courant possible avec un dispositif coaxial, et il faut tenir compte de la valeur de la résistance de charge $R_o l$ et l'inductance $L_o$ de la bobine pour régler le front de montée du générateur.

Cependant, une première approche permet de considérer que si la durée de transition du générateur est nulle, alors le courant perturbateur $I_p$ (t) circulant dans le dispositif plan conforme à celui de la figure 10 est assimilable à un échelon d'amplitude $I_{po}$ et de front de montée $t_{do} = t_o$, c'est-à-dire déterminé par l'inductance de la bobine et par la résistance de charge $R_o l$. En fait, le front de montée est déterminé par la tangente à l'origine à la courbe $I_p$ (t). C'est ce que l'on a illustré sur la courbe (2) de la figure 12, où on a représenté en trait interrompu un trapèze enveloppant la courbe $I_p$ (t).

La mise en oeuvre de cette seconde variante pour tester des cordons en bobine met à profit de façon très intéressante cette particularité. En effet, comme il va être montré ci-après, c'est essentiellement la valeur de la résistance de charge $R_o l$ qui détermine le front de montée du courant $I_p$ (t), de façon que d'éventuels couplages magnétiques dus à un défaut du cordon soient mis en évidence.

La relation (3) présentée plus avant dans la description a montré la valeur du pic de tension susceptible d'apparaître lorsqu'il existe des couplages magnétiques à l'intérieur du cordon. Cette relation est rappelée pour mémoire :

$$V_p = \tfrac{1}{2} (R_o + L_t/t_r) I_{po}$$

Par ailleurs, il a été établi que la durée de la transition $t_r$, correspondant au front de montée du générateur, ne doit pas être trop grande pour permettre de mettre en évidence les couplages magnétiques dus aux défauts du câble, mais néanmoins il peut être réglé de façon telle que les couplages magnétiques conformes puissent être atténués. Une approche plus précise, vérifiée par des essais, consiste à choisir la valeur suivante pour le front de montée :

$$t_r = 3 L_t/R_o \quad (9)$$

Cependant, la valeur mise en évidence par la relation (9) est valable seulement si le courant est effectivement un échelon d'amplitude $I_{po}$, et de front de montée constant. Lorsque la montée du courant est exponentielle, comme c'est le cas avec un circuit perturbateur réalisé par une bobine posée sur une plaque isolée, alors il faut que la valeur du front de montée $t_{do}$ d'un tel circuit perturbateur soit en fait nettement inférieure à la limite imposée par la relation (9), pour que les couplages magnétiques dus à un défaut du câble puissent être mis en évidence. En effet, si la constante de temps $t_{do}$ du circuit perturbateur réalisé par la bobine et le plan conducteur isolé est identique à la constante de temps du courant perturbateur qui serait appliqué dans une structure coaxiale, les couplages magnétiques dus à un défaut du câble risquent de ne pas être mis en évidence. Il faut donc que la constante de temps $t_{do}$ du circuit perturbateur constitué par la bobine et le plan conducteur soit nettement inférieure à la limite imposée par la relation (9), pour compenser le fait que le courant perturbateur croît de façon exponentielle.

Des essais ont permis de montrer qu'un compromis intéressant est obtenu lorsque la constante de temps $t_{do}$ d'un tel circuit perturbateur obéit à la relation suivante :

$$t_{do} = L_t /10R_o \quad (10)$$

Des relations (7) et (10), on en déduit qu'un compromis intéressant consiste à choisir pour $R_o l$ la valeur suivante :

$$R_o l = 10R_o.L_o/L_t \quad (11)$$

Bien entendu, il est possible de choisir une valeur supérieure pour la résistance de charge $R_o l$ du circuit

perturbateur constitué par le cordon conditionné en bobine et par un plan métallique (70) recouvert d'un écran isolant (71), mais dans ce cas il existe des risques non négligeables que des couplages magnétiques acceptables dans un câble conforme soient alors trop mis en évidence lors de la mesure. En fait, il faut que la résistance de charge $R_o l$ s'approche de la valeur édictée par la relation 11, mais demeure néanmoins proche de l'impédance caractéristique de la structure constituée par le blindage du cordon et le dispositif conducteur (70). En fait, la valeur de la résistance $R_o l$ sera un compromis entre ces deux valeurs, et la durée de la transition sera ensuite ajustée en faisant varier le front de montée du générateur. Ainsi, par exemple, ceci permet de choisir pour la résistance à charge $R_o l$ une valeur fixe de $50\Omega$ pour des cordons de longueur inférieure ou égale à 10m et une valeur de $500\Omega$ au-delà. Ces valeurs semblent être en effet de bons compromis.

En d'autres termes, la durée de la transition est une résultante de l'influence de la résistance de charge $R_o l$ et de la durée de transition du générateur.

Les valeurs de la résistance de transfert $R_o$ de l'inductance de transfert $L_t$, et de l'inductance $L_o$ d'un câble conditionné en bobine peuvent être déterminées, pour un type donné de cordon, pendant la phase préparatoire, en effectuant des mesures sur plusieurs échantillons, comme ceci sera expliqué ci-après.

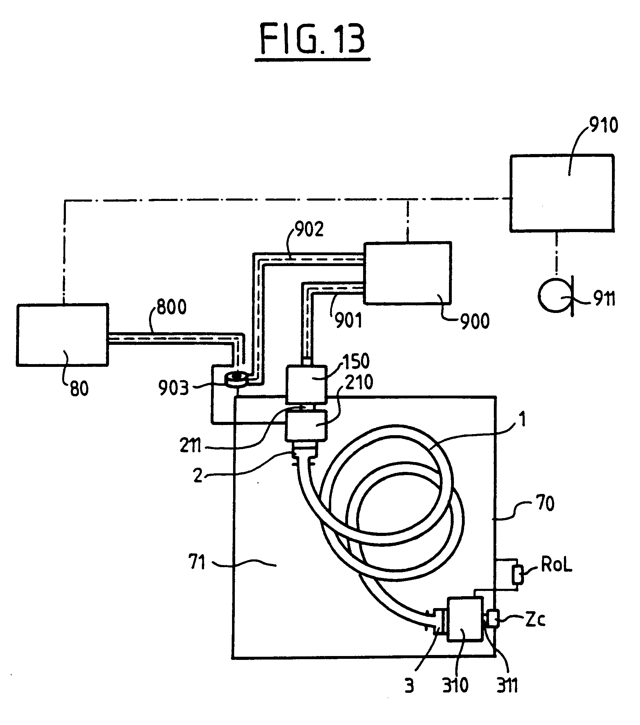

La figure 13 représente le mode de réalisation préférée d'un dispositif pour tester des cordons conditionnés en bobine.

En fait, la figure 13 fait apparaître de façon plus détaillée les éléments apparaissant sur la figure 10, et fait apparaître quelques organes complémentaires.

Les éléments déjà décrits sur la figure 10 possèdent les mêmes références sur cette figure 13. Par ailleurs, la figure 13 comporte un certain nombre de points communs avec ce qui a été décrit en regard de la figure 9.

Le cordon, constitué du câble (1) et de ses deux connecteurs, est placé sur l'écran isolant (71) (ou un dispositif d'isolement équivalent) recouvrant le plan métallique (70) (ou le dispositif conducteur) non visible sur cette figure. Un premier connecteur (2) est relié à une première face d'un boîtier interface (210). Le second connecteur (3) est relié à une première face d'un second boîtier interface (310). La seconde face du premier boîtier interface (210) est reliée par l'intermédiaire d'une liaison (211) à l'entrée d'un amplificateur de tension (150). La liaison (211) assure en fait la connexion entre l'entrée de l'amplificateur (150) et le conducteur intérieur du cordon sur lequel est effectuée la mesure. La seconde face du second boîtier interface (310) permet d'assurer la liaison entre l'autre extrémité du conducteur sur lequel est effectuée la mesure et le blindage du cordon par l'intermédiaire d'une impédance de charge ($Z_c$). Une liaison (311) assure l'interconnexion entre le boîtier et la résistance de charge.

Dans un mode de mise en oeuvre préférée, la liaison (211) entre la seconde face du premier boîtier interface (210) et l'amplificateur de tension (150) est une liaison coaxiale au standard de 50 ohms, de même que la liaison (311) entre le second boîtier interface (310) et l'impédance de charge ($Z_c$). Par ailleurs, cette impédance de charge ($Z_c$) est par exemple également une impédance de charge coaxiale dont la valeur est identique à la valeur de l'impédance d'entrée de l'amplificateur, et une liaison filaire dans le premier boîtier relie le conducteur sur lequel est effectué le test à l'entrée de l'amplificateur (150), et une seconde liaison filaire dans le second boîtier relie l'autre extrémité du conducteur sur lequel est effectué le test à l'impédance de charge ($Z_c$).

Dans un mode de mise en oeuvre, l'impédance de charge ($Z_c$) et l'impédance d'entrée de l'amplificateur ont une valeur de 50 ohms.

Par ailleurs, le blindage du second boîtier (310) est relié au plan métallique (70) par l'intermédiaire d'une résistance de charge $R_o l$, dont le mode de calcul de la valeur a été illustré précédemment. La sortie d'un générateur (80) est reliée au plan métallique (70), par exemple par l'intermédiaire du fil conducteur d'une liaison coaxiale (800), alors que la masse du générateur est reliée à la masse du premier boîtier interface (210). Comme expliqué précédemment, le générateur (80) est un générateur d'impulsions de tension, dont la durée du front de transition (en montée ou en descente) peut être pilotée et variable.

La sortie de l'amplificateur (150) est reliée à une première entrée du dispositif de mesure (900), par l'intermédiaire d'une liaison (901).

Comme dans le cas de la figure 9, le dispositif de mesure (900) est par exemple un numériseur double voie, tel qu'un oscilloscope numérique.

La seconde entrée du dispositif de mesure (900) est reliée, par l'intermédiaire d'une liaison (902) à un capteur (903) du courant perturbateur. Le capteur (903) est par exemple un transformateur de courant large bande, de structure torique, qui est placé sur le conducteur reliant la partie centrale de la liaison (800), c'est-à-dire autour du conducteur qui relie le générateur au plan métallique (70). La fonction de ce transformateur est de mesurer le courant perturbateur $I_p$ (t) par conversion courant / tension.

Les liaisons (901, 902) aboutissant à chaque entrée du dispositif de mesure (900) sont par exemple des câbles coaxiaux.

Enfin, le dispositif comporte un appareil (910) pour gérer le test. Cet appareil est par exemple un microcalculateur relié à une base de données (911), comportant les signatures de référence de chaque type de cordon, de même que les résultats de chacun des tests successifs, afin de réaliser une autodocumentation de la base de données. L'appareil (910) est donc relié à la base de données (911), et il est également relié au générateur (80) et à l'appareil de mesure (900). Ainsi, pendant les phases de tests, un échange peut avoir lieu entre l'appareil de mesure (900) et l'appareil de gestion (910) pour que celui-ci pilote le générateur (80) de sorte que, pour un type donné de cordon, le courant perturbateur approprié soit injecté dans l'ensemble plan excitateur (70), résistance de charge et blindage du cordon.

Comme évoqué précédemment, et de même qu'avec le montage de la figure 9, un test utilisant ce dispositif de la figure 10 se déroule en deux phases, qui sont respectivement une phase préparatoire et une phase de test.

Etant donné que le test s'adresse à des séries importantes de cordons, il est nécessaire qu'il soit subordonné à cette phase préparatoire dont l'objectif est de déterminer le comportement électromagnétique d'un cordon, et d'évaluer, pour un type donné de cordon, la signature de référence sur laquelle est établie la conformité ou non de la qualité du blindage.

Ainsi qu'il a été expliqué auparavant, la totalité de la phase préparatoire et du test peut être réalisée à l'aide d'un dispositif conforme à celui de la figure 9, si les cordons sont de faible longueur.

Par contre, si les cordons sont de longueur plus importante, mais se trouvent conditionnés en bobine, alors une partie seulement de la phase préparatoire se déroule à l'aide d'un dispositif conforme à celui de la figure 9, c'est-à-dire à l'aide d'une structure coaxiale, et la fin de la phase préparatoire, de même que les phases de test, se déroulent à l'aide d'un dispositif conforme à celui des figures 10 et 13.

Les opérations qui se déroulent lorsque seulement le dispositif de la figure 9 est utilisé pour les phases préparatoires et les phases de test ont déjà été décrites, et en conséquence ce qui suit illustre les phases préparatoires et les phases de test dans le cas où les cordons sont conditionnés en bobine.

La phase préparatoire consiste à installer un cordon du type de ceux qui seront testés en bobine, dans un tube métallique ou à recouvrir la face externe du cordon d'une enveloppe métallique souple, en utilisant le montage de la figure 9. Le tube métallique sera utilisé lorsque le type de cordon est de dimension faible, par exemple de dimension de l'ordre de deux mètres au maximum, alors qu'une enveloppe métallique souple sera utilisée pour les cordons de dimension supérieure.

Le générateur d'impulsion (8), le numériseur (9) et l'amplificateur de tension (15) seront connectés conformément au schéma de la figure 9, de façon à ce qu'une liaison coaxiale soit réalisée autour du cordon.

Cette mesure préliminaire, effectuée en début de phase préparatoire, a pour but de rechercher dans la tension résultante suite au passage d'un courant perturbateur donné, de front de montée déterminé, l'origine des couplages électromagnétiques provoqués par un cordon conforme. En conséquence, de préférence, il faut que cette mesure préliminaire soit effectuée avec un cordon dont la conformité a pu être vérifiée par ailleurs à l'aide d'un autre procédé.

Le générateur injecte des impulsions récurrentes de courant dont la forme correspond à celle des impulsions de la figure 3, et la tension résultante obtenue au niveau du conducteur (10) relié à la chaîne de mesure est relevée. Cette tension provoque une signature typique identique ou semblable à celle de la figure 4.

La connaissance de la valeur du palier de tension $V_o$, et la connaissance du courant maximum $I_{po}$ injecté permet de déduire la valeur du couplage résistif $R_o$, en application de la relation (4) qui donne la valeur de ce palier $V_o$ en fonction du courant maximum en palier $I_{po}$ et de la résistance de transfert $R_o$ ; dès lors que la résistance de transfert $R_o$ a été déterminée, la mesure de la tension maximum $V_p$ qui apparaît pendant la transition permet de calculer la valeur de l'inductance $L_t$ apparaissant dans un câble conforme, par application de la relation (3) qui donne cette valeur en fonction de la résistance de transfert $R_o$, de la durée de la transition $t_r$, et enfin de la valeur du palier de courant $I_{po}$.

En outre, cet essai préliminaire permet de déterminer la durée du front de montée $t_r$ qui sera utilisée dans la suite du test. En effet, il est possible de choisir cette durée $t_r$ de manière qu'aucun pic de tension ne soit mis en évidence pendant la transition sur un câble conforme, c'est-à-dire de façon que le pic $V_p$ soit inférieur au palier de tension $V_o$ lorsque le courant a atteint son propre palier. En fait, la durée $t_r$ est choisie pour que des couplages acceptables ne soient pas mis en évidence.

Une seconde étape de la phase préparatoire consiste à évaluer l'inductance $L_o$ de la bobine composant le cordon, suite à son conditionnement en sortie de chaîne de production. Pour cela, pour un type de cordon donné, un cordon témoin est posé sur la face isolante (71) du plan excitateur (70). Un échelon de tension, par exemple, est injecté dans le montage, et la mesure du courant résultant de la tension injectée permet de déterminer l'inductance de la bobine ainsi constituée. A partir du moment où l'inductance $L_o$ de la bobine a été ainsi déterminée, il est possible de fixer la valeur de la résistance $R_ol$ de charge du circuit excitateur qui sera utilisée pour les tests de cordons du même type, en s'approchant de la condition édictée par la relation (11) présentée auparavant, c'est-à-dire que $R_ol$ doit être un compromis entre la valeur $10R_o.L_o/L_t$ et l'impédance caractéristique du blindage et du plan conducteur (70).

La phase préparatoire comporte enfin une troisième étape qui consiste à rechercher la signature de référence. L'expérience montre que pour un type donné de cordon, il est préférable d'effectuer un prélèvement de plusieurs cordons du même type sur plusieurs lots de fabrication, afin d'établir cette signature, car la résistance de transfert $R_o$ peut varier d'un cordon du même type à l'autre. Des essais effectués sur une dizaine de cordons environ permettent d'obtenir une signature de référence assez représentative. En fait, la signature de référence est la valeur moyenne des tensions résultantes mesurées, sur des cordons conformes, en réponse à un courant perturbateur donné.

Les informations recueillies au cours de la phase préparatoire peuvent alors être entrées dans la base de données (911).

Il est clair que la base de données peut contenir les informations ou les paramètres d'un grand nombre de cordons de types différents. A chaque type de cordon sera associée une référence dans la base de données, qui permettra la recherche automatique de la signature conforme mémorisée dans la base de données.

Une opération de test consistera donc, pour l'opérateur, à connecter chaque cordon à tester sur les boîtiers interfaces, et à introduire la référence du cordon testé.

L'introduction de la référence permettra en outre que les paramètres de réglage du générateur (durée de la transition, valeur du palier de tension) et de la chaîne de mesure soient calibrés par les moyens de traitement dès la procédure d'initialisation du test.

Des moyens complémentaires, appartenant à la chaîne de mesure ou connectés à celle-ci, permettront que l'opérateur soit informé en fin d'exécution du test de la qualité du blindage d'un cordon testé, selon l'un des critères suivants : mauvais, douteux ou bon.

Cependant, il sera préférable que les résultats des mesures effectuées sur chaque cordon soient mémorisés afin que, si nécessaire, des analyses plus précises de chacun des résultats soient effectuées postérieurement au test.

Le procédé de l'invention est donc particulièrement avantageux puisqu'il permet d'apprécier la qualité du blindage électromagnétique de divers types de cordons avec une relativement bonne précision, et ce sans qu'il soit nécessaire de procéder à des manipulations longues et fastidieuses.

Un autre avantage de l'invention est qu'elle permet non seulement de vérifier la qualité du blindage électromagnétique du cordon lui-même, mais encore elle permet d'estimer si le cordon, lorsqu'il sera connecté à deux appareils lors des utilisations, aura un comportement satisfaisant. En effet, il peut arriver qu'un connecteur soit déformé, d'une façon telle que le blindage d'un connecteur du cordon ne soit pas en contact parfait avec le blindage du connecteur correspondant de l'appareil relié audit cordon. Cette mauvaise connexion peut être à l'origine de perturbations électromagnétiques, de la même façon que lorsqu'il existe un défaut de blindage dans le cordon lui-même. Lorsque ce défaut existe, le procédé de l'invention permet de le mettre en évidence. En effet, comme la description le montre, le procédé de l'invention nécessite, pour sa mise en oeuvre, que chaque connecteur d'un cordon soit relié à un boîtier interface qui appartient au dispositif de mise en oeuvre. Pour que la mesure soit la plus précise possible, il faut que le boîtier interface soit en mesure de coopérer le plus parfaitement possible avec le connecteur correspondant, et qu'en particulier une bonne continuité électrique soit assurée entre le boîtier et le connecteur. En conséquence, chaque boîtier interface doit être agencé pour coopérer parfaitement avec un connecteur conforme. Si le connecteur est légèrement déformé, et présente donc un défaut de conformité, alors la liaison entre le connecteur déformé et le boîtier interface correspondant présente un couplage résistif de valeur plus importante que dans le cas où le connecteur ne serait pas détérioré, il en résulte que cette augmentation de couplage résistif entraîne une augmentation de la valeur du palier de tension mesuré, de la même manière que s'il s'agissait d'une rupture de contact à l'intérieur du cordon lui-même. Bien entendu, c'est seulement un examen plus approfondi du cordon qui permettra de déterminer l'origine du défaut. Cependant, on constate donc que le procédé d'invention permet de mettre en évidence tous les défauts de blindage dont le cordon peut être à l'origine, soit parce que la continuité du blindage n'est pas assurée, ou est assurée de façon insatisfaisante entre les deux extrémités du cordon, ou soit parce l'un et/ou l'autre des connecteurs d'extrémité du cordon n'est pas conforme, par exemple parce que son blindage est déformé, de sorte qu'un défaut de contact pourra exister entre le cordon et l'un ou l'autre des appareils auxquels il sera connecté lors de ses utilisations.

## Revendications

1. Procédé pour vérifier l'efficacité du blindage électromagnétique (14, 25, 35) d'un cordon conducteur formé de deux connecteurs (2, 3) reliés par un câble blindé (1) incorporant au moins un conducteur (10, 11, 12, 13), consistant à injecter dans le blindage du cordon un signal perturbateur périodique et à mesurer un signal résultant apparaissant sur l'un (10) des conducteurs du câble en réponse au passage du signal perturbateur, caractérisé en ce que le signal perturbateur est un signal de courant (Ip (t)) fait de transitions entre deux paliers (0, Ipo) et le signal résultant est un signal de tension (Vr (t)) alternant entre deux paliers (0, Vo) correspondants, la valeur de l'un des deux paliers de tension étant directement fonction de la résistance de transfert (Ro) du cordon et du palier de courant correspondant, et en ce que le procédé comporte en outre une phase préparatoire consistant à déterminer sur un type de cordon conforme la durée des transitions du signal de courant de façon que le signal résultant de référence, appelé signature de référence, présente un pic de tension (Vp) lorsqu'il existe un défaut de couplage électromagnétique (Lt) dans le cordon, tout en masquant les couplages électromagnétiques acceptables du cordon, et une phase de tests consistant à déterminer la conformité de cordons du même type en les soumettant au même signal de courant et en comparant leur signal résultant avec la signature de référence.

2. Procédé selon la revendication 1, caractérisé en ce que le signal de courant est fait d'impulsions de courant qui s'apparentent à des trapèzes de période T, de largeur t1 et ayant des transitions déterminées de la façon précitée pendant la phase préparatoire.

3. Procédé selon la revendication 1 ou 2, caractérisé en ce que chaque extrémité (101, 102) du conducteur (10) sur lequel est effectuée la mesure est reliée au blindage du connecteur le plus proche par l'intermédiaire d'une résistance de charge (R1, R2), de sorte qu'une partie du courant perturbateur passe par le conducteur (10) et une partie passe par le blindage (14, 25, 35) du cordon, c'est-à-dire dans la chaîne formée par le blindage du câble et de chaque connecteur.

4. Procédé selon la revendication 3, caractérisé en ce que les résistances de charge (R1, R2) sont identiques, de sorte que ledit palier de tension a la valeur $V_o = \frac{1}{2}$ Ro Ipo et que pendant la transition le pic de tension a la valeur $Vp = \frac{1}{2}$ (Ro + Lt/tr) Ipo, et en ce que pendant la phase préparatoire la durée de la transition (tr) est réglée de façon que tr >> Lt/Ro, qui fait que le pic de tension qui apparaît pendant la transition est quasiment confondu avec la valeur dudit palier de tension (Vo).

5. Procédé selon l'une des revendications 1 à 4, caractérisé en ce que la phase préparatoire est faite à partir d'échantillons de cordons conformes du même type et la signature de référence est la moyenne obtenue des signaux de tension résultants.

6. Procédé selon la revendication 5, caractérisé en ce que les cordons étant conditionnés d'une façon quelconque, la phase préparatoire consiste à placer les cordons échantillons dans un conduit coaxial (7) métallique, à relier l'extrémité du conduit (7) à l'un (3) des connecteurs, par l'intermédiaire d'une résistance de charge (R$_l$), dont la valeur est proche de celle de l'impédance caractéristique de l'ensemble constitué par le conduit (7) et le blindage du cordon, à relier l'autre (2) connecteur à la sortie d'un générateur d'impulsions (8), à relier la masse du générateur d'impulsions (8) à l'extrémité correspondante du conduit (7) métallique, à relier d'une part une extrémité du conducteur (10) au blindage (35) du connecteur (3), côté résistance de charge (R$_l$), par l'intermédiaire d'une impédance de charge (Z$_c$), à relier l'autre extrémité du conducteur (10) à une chaîne de mesure (9, 15), dont l'impédance d'entrée est égale à l'impédance de charge (Z$_c$) placée à l'autre extrémité, de sorte que l'impédance d'entrée de la chaîne de mesure (9, 15) et l'impédance de charge (Z$_c$) constituent respectivement les résistances de charge (R1, R2) reliant chaque extrémité du conducteur (10) au blindage (25, 35) du connecteur (2, 3) correspondant, et en ce qu'il consiste, après détermination de la durée de la transition nécessaire, pour un type de cordon donné, de même qu'après la détermination de la signature de référence, à utiliser un montage identique pour la phase de tests.

7. Procédé selon la revendication 5, caractérisé en ce que les cordons à tester étant conditionnés en bobine : la phase de tests consiste à tester chaque cordon en le plaçant sur des moyens isolants tels qu'un écran isolant (71) recouvrant un plan conducteur excitateur (70) ; le courant perturbateur (I$_p$(t)) de durée de transition (t$_r$) déterminée est obtenu en reliant l'un des connecteurs par l'intermédiaire d'une résistance de charge (R$_o$l) au plan conducteur excitateur (70), en reliant la sortie d'un générateur de tension (80) au plan conducteur (70), et en reliant la masse du générateur au blindage (25) de l'autre connecteur (2) ; et la phase préparatoire consiste à faire en sorte que, avec le montage ainsi réalisé, si un échelon de tension de durée de transition négligeable et de valeur finale (E$_o$) non nulle est injecté dans le circuit constitué par le plan métallique et le blindage du connecteur, alors le courant perturbateur (I$_p$(t)) en résultant, qui circule dans le blindage du cordon, est influencé par le conditionnement de ce dernier en bobine et est assimilable à un échelon de courant de valeur finale (I$_{po}$), croissant de façon exponentielle, selon la relation :

$$I_p(t) = I_{po} (1 - e^{- t/to}),$$

dans laquelle I$_{po}$ = E$_o$/R$_o$l, et t$_o$ est la constante du circuit constituée par l'inductance du cordon (L$_o$) et la résistance de charge (R$_o$l) d'extrémité, soit t$_o$ = L$_o$/R$_o$l, la phase préparatoire consistant en outre à déterminer entre la valeur de l'inductance (L$_o$) du cordon conditionné en bobine et à choisir en conséquence la valeur de la résistance de charge ($R_o$l) pour que la tension ($V_r(t)$), qui apparaît sur le conducteur (10) sur lequel est effectuée la mesure, permette de mettre en évidence d'éventuels défauts de couplage électromagnétique, en intervenant éventuellement, si nécessaire, sur la durée de transition de l'échelon de tension après que la résistance de charge ait été fixée.

8. Procédé selon la revendication 7, caractérisé en ce que la phase préparatoire consiste : à déterminer l'origine des couplages électromagnétiques provoqués par un cordon conforme, en plaçant le cordon dans un conduit métallique (7) souple, relié à l'une de ses extrémités, par l'intermédiaire d'une résistance de charge ($R_l$), au blindage (35) de l'un (3) des connecteurs, et relié, par son autre extrémité, à la sortie d'un générateur d'impulsions (8), la masse du générateur d'impulsions étant reliée au blindage (25) de l'autre connecteur (2), un conducteur (10) du câble étant par ailleurs relié, par chacune de ses extrémités, par l'intermédiaire de deux résistances (R1, R2) au blindage de chacun des connecteurs, et à déterminer, en injectant des échelons de tension de front de transition de durée non nulle, la valeur de la résistance de transfert ($R_o$) du cordon conforme, et la valeur de l'inductance ($L_t$) de transfert d'un cordon conforme ;
   - à déterminer la durée ($t_r$) du front de montée qu'il faut utiliser dans la suite du test, de façon que pour un cordon conforme, aucun pic de tension ne soit mis en évidence pendant la transition;
   - à évaluer l'inductance ($L_o$) de la bobine composant le cordon, en plaçant celui-ci en bobine sur les moyens isolants (71) d'un plan conducteur (70), et à déterminer la valeur de la résistance ($R_o$l) du circuit excitateur, en fonction de la valeur mesurée de la résistance de transfert ($R_o$), de l'inductance de transfert ($L_t$) et de l'inductance de la bobine ($L_o$) ;
   - et à rechercher la signature de référence, en relevant, pour plusieurs cordons la tension résultante ($V_r(t)$) apparaissant entre le conducteur (10) et le blindage (25) de l'un des connecteurs et en calculant la valeur moyenne.

9. Procédé selon la revendication 8, caractérisé en ce que la valeur de la résistance de charge ($R_o$l) du circuit excitateur constitué par le plan métallique et la bobine est telle que la constante de temps ($t_o$) de ce circuit soit inférieure à la durée de la transition ($t_r$) du courant ($I_p(t)$) qu'il faut appliquer lorsque le cordon, au lieu d'être posé sur le plan excitateur, est dans un tube coaxial (7).

10. Procédé selon la revendication 9, caractérisé en ce que la valeur de la résistance ($R_o$l) est un compromis entre la valeur suivante : $R_o$l = $10 R_o.L_o/L_t$ et la valeur de l'impédance caractéristique de l'ensemble constitué par le plan excitateur (70) et le blindage du cordon, et en ce que l'ajustage de la durée de transition lors des phases de test s'effectue en intervenant sur la durée de transition de l'échelon de tension injecté à partir du générateur (80) de tension.

11. Dispositif pour la mise en oeuvre du procédé selon la revendication 6, caractérisé en ce qu'il comporte, pour la phase préparatoire et pour la phase de tests des moyens identiques, constitués d'une part par une enveloppe métallique (7), reliée à l'une de ses extrémités au blindage d'un boîtier interface (300), par l'intermédiaire d'une résistance de charge ($R_l$), une iiaison étant en outre assurée à l'intérieur du boîtier (300) entre l'extrémité d'un conducteur (10) du câble et le blindage dudit boîtier par l'intermédiaire d'une impédance de charge ($Z_c$), le blindage du boîtier étant par ailleurs connecté au blindage (35) de l'un des connecteurs (3) du cordon,
   - en ce que le blindage (25) de l'autre (2) connecteur est relié à un second (200) boîtier interface, et assure la liaison entre l'autre extrémité du conducteur (10) et l'entrée d'une chaîne (9, 15) de mesure, dont l'impédance d'entrée est égale à l'impédance de charge ($Z_c$), de sorte que l'impédance d'entrée de la chaîne de mesure (9, 15) et l'impédance de charge (Zc) constituent respectivement les résistances (R1, R2) reliant chaque extrémité du conducteur (10) au blindage (25, 35) du connecteur (2, 3) correspondant, et en ce que ce blindage est par ailleurs relié à la sortie d'un générateur d'impulsions (8),
   - et en ce que la chaîne de mesure (9, 15) comporte des moyens (92, 93, 94) pour mesurer le courant ($I_p(t)$) circulant dans le circuit excitateur constitué par le blindage du cordon, la résistance de charge ($R_l$) et le tube métallique (7), et des moyens pour mesurer la tension ($V_r(t)$) entre le conducteur (10) et l'un des connecteurs et des moyens pour comparer cette tension à une tension de référence obtenue pour un courant ($I_p(t)$) donné.

12. Dispositif pour la mise en oeuvre du procédé selon la revendication 6, caractérisé en ce qu'il comporte, pour déterminer dans un cordon conforme l'origine des couplages électromagnétiques, et ainsi en déduire la résistance de transfert ($R_o$) d'un cordon conforme et son inductance de transfert ($L_t$), un dispositif selon la revendication 11, et en ce qu'il comporte en outre, pour terminer la phase préparatoire et effectuer la phase de test, un plan métallique (70), recouvert d'un écran isolant (71), sur lequel les cordons conditionnés en bobine peuvent être posés,

- en ce qu'il comporte un premier boîtier (210) pour relier un conducteur (10) au cordon à l'entrée d'une chaîne de mesure (150, 900) d'une part, premier boîtier dont le blindage est relié à la masse d'un générateur (80) d'impulsions de tension dont la durée du front de montée peut être variable, de même que la valeur du palier, la sortie du générateur d'impulsions étant reliée au plan métallique (70),
- en ce qu'il comporte un second boîtier (310) assurant l'interface entre l'autre extrémité du conducteur (10) et une impédance de charge ($Z_c$) dont la valeur est égale à celle de l'impédance d'entrée de la chaîne de mesure, de sorte que l'impédance d'entrée de la chaîne de mesure (900, 150) et l'impédance de charge (Zc) constituent respectivement les résistances (R1, R2) reliant chaque extrémité du conducteur (10) au blindage (25, 35) du connecteur (2, 3) correspondant, le blindage de ce second boîtier étant par ailleurs relié au plan métallique (70) par l'intermédiaire d'une résistance de charge ($R_o$l) de valeur prédéterminée,
- et en ce que la chaîne de mesure (150, 900) comporte des moyens (903) pour mesurer le courant perturbateur circulant dans le circuit constitué par le blindage du cordon, la résistance de charge le plan métallique (70) et le générateur (80), et des moyens pour mesurer la tension ($V_r(t)$) entre le conducteur (10) et l'un des connecteurs et des moyens pour comparer cette tension à une tension de référence obtenue pour un courant ($I_p(t)$) donné.

13. Dispositif selon la revendication 12, caractérisé en ce que la chaîne de mesure (150, 900) et le générateur (80) sont reliés à une unité de traitement et de commande (910) permettant de piloter le générateur (80) pour obtenir un courant perturbateur ($I_p(t)$) souhaité.

14. Dispositif selon l'une des revendications 11 à 13, caractérisé en ce que la chaîne de mesure (9, 15 ; 900, 150) comporte un amplificateur de tension (15, 150), et un oscilloscope numérique (9, 900), et en ce que les moyens (94, 903) pour mesurer le courant circulant dans le circuit excitateur sont constitués par un transformateur torique passif.

15. Dispositif selon la revendication 13 ou 14, caractérisé en ce que la chaîne de mesure est reliée à une banque de données (911) permettant de mesurer les paramètres nécessaires à la réalisation du test sur plusieurs types de cordons, et de réactualiser lesdites données.

**Patentansprüche**

1. Verfahren zur Überprüfung der Wirksamkeit der elektromagnetischen Abschirmung (14, 25, 35) einer Leiterschnur, die aus zwei durch ein abgeschirmtes Kabel (1) verbundenen Verbindern (2, 3) gebildet ist, das wenigstens einen Leiter (10, 11, 12, 13) umfaßt, darin bestehend, daß in die Abschirmung der Schnur ein periodisches Störsignal eingespeist wird und ein resultierendes Signal gemessen wird, das an einem (10) der Leiter des Kabels in Reaktion auf den Durchgang des Störsignals erscheint, dadurch gekennzeichnet, daß das Störsignal ein Stromsiganl (Ip(t)) aus Übergängen zwischen zwei Stufen (O, Ipo) besteht und das resultierende Signal ein Spannungssignal (Vr(t)) ist, das zwischen zwei entsprechenden Stufen (O, Vo) alterniert, wobei der Wert einer der beiden Spannungsstufen direkt von dem Übertragungswiderstand (Ro der Schnur und der entsprechenden Stromstufe abhängt, und daß das Verfahren ferner eine Vorbereitungsphase aufweist, die darin besteht, an einem entsprechenden Schnurtyp die Dauer der Übergänge des Stromsignals so zu bestimmen, daß das resultierende Bezugssignal, die sogenannte Bezugssignatur, eine Spannungsspitze (Vp) aufweist, wenn in der Schnur ein elektromagnetischer Kopplungsfehler (Lt) besteht, wobei gleichzeitig die akzeptablen elektromagnetischen Kopplungen der Schnur maskiert werden, sowie eine Testphase, die darin besteht, die Entsprechung von Schnüren des gleichen Typs zu bestimmen, indem sie dem gleichen Stromsignal unterworfen werden und ihr resultierendes Signal mit der Bezugssignatur verglichen wird.

2. Verfahren nach Anspruch 1, dadurch gekennzeichnet, daß das Stromsignal aus Stromimpulsen besteht, die Trapezen mit der Periode T mit einer Breite t1 ähneln, und Übergänge aufweisen, die auf die obengenannte Weise während der Vorbereitungsphase bestimmt sind.

3. Verfahren nach Anspruch 1 oder 2, dadurch gekennzeichnet, daß jedes Ende (101, 102) des Leiters (10), an dem die Messung durchgeführt wird, über einen Lastwiderstand (R1, R2) so mit der Abschirmung des nächsten Verbinders verbunden ist, daß ein Teil des Störstroms durch den Leiter (10) und ein Teil durch die Abschirmung (14, 25, 35) der Schnur, d.h. in der durch die Abschirmung des Kabels und jedes Verbinders gebildeten Kette fließt.

4. Verfahren nach Anspruch 3, dadurch gekennzeichnet, daß die Lastwiderstände (R1, R2) identisch sind, so daß die Spannungsstufe den Wert $V_o = 1/2$ Ro Ipo aufweist und die Spannungsspitze während des Übergangs den Wert Vp = 1/2(Ro + Lt/tr) Ipo aufweist, sowie daß die Übergangsdauer (tr) während der Vorbereitungsphase so eingestellt wird, daß tr >> Lt/Ro, womit die während des Übergangs erscheinende Spannungsspitze gewissermaßen mit dem Wert der Spannungsstufe (Vo) zusammenfällt.

5. Verfahren nach einem der Ansprüche 1 bis 4, dadurch gekennzeichnet, daß die Vorbereitungsphase ausgehend von entsprechenden Schnurproben des gleichen Typs durchgeführt wird und die Bezugssignatur der aus den resultierenden Spannungssignalen erhaltene Mittelwert ist.

6. Verfahren nach Anspruch 5, dadurch gekennzeichnet, daß bei in beliebiger Weise gefertigten Schnüren die Vorbereitungsphase darin besteht, die Probenschnüre in ein koaxiales Metallrohr (7) zu setzen, das Ende des Rohrs (7) mit einem (3) der Verbinder über einen Lastwiderstand (R1) zu verbinden, dessen Wert demjenigen der charakteristischen Impedanz der durch das Rohr (7) und die Abschirmung der Schnur gebildeten Einheit nahekommt, den anderen (2) Verbinder mit dem Ausgang eines Impulsgenerators (8) zu verbinden, die Masse des Impulsgenerators (8) mit dem entsprechenden Ende des Metallrohrs (7) zu verbinden, einerseits über eine Verbraucherimpedanz ($Z_c$) ein Ende des Leiters (10) mit der Abschirmung (35) des Verbinders (3) an der Seite des Lastwiderstandes ($R_1$) zu verbinden, das andere Ende des Leiters (10) mit einem Meßgerät (9, 15) zu verbinden, dessen Eingangsimpedanz gleich der am anderen Ende sitzenden Verbraucherimpedanz ($Z_c$) ist, so daß die Eingangsimpedanz des Meßgeräts (9, 15) und die Verbraucherimpedanz ($Z_c$) jeweils die Lastwiderstände (R1, R2) bilden, die jedes Ende des Leiters (10) mit der Abschirmung (25, 35) des entsprechenden Verbinders (2, 3) verbinden, und daß es nach der Bestimmung der erforderlichen Übergangsdauer für einen gegebenen Schnurtyp ebenso wie nach der Bestimmung der Bezugssignatur darin besteht, eine identische Anordnung für die Testphase zu verwenden.

7. Verfahren nach Anspruch 5, dadurch gekennnzeichnet, daß bei als Spulen gefertigten zu testenden Schnüren die Testphase aus dem Testen jeder Schnur besteht, indem sie auf isolierende Mittel wie einen Isolierschirm (71) gesetzt werden, der eine leitende Erregerebene (70) überdeckt; der Störstrom ($I_p(t)$) mit einer bestimmten Übergangsdauer ($t_r$) erhalten wird, indem einer der Verbinder über einen Lastwiderstand ($R_oI$) mit der leitenden Erregerebene (70) verbunden wird, wobei der Ausgang eines Spannungsgenerators (80) mit der leitenden Ebene (70) und die Masse des Generators mit der Abschirmung (25) des anderen Verbinders (2) verbunden wird; und daß die Vorbereitungsphase darin besteht, so vorzugehen, daß dann, wenn bei der so realisierten Anordnung eine Spannungsstufe mit einer zu vernachlässigenden Übergangsdauer und mit einem nicht bei Null liegenden Endwert ($E_0$) in den durch die Metallebene und die Abschirmung des Verbinders gebildeten Kreis eingespeist wird, der sich daraus ergebende Störstrom ($I_p(t)$), der in der Abschirmung der Schnur zirkuliert, durch deren spulenförmige Ausgestaltung beeinflußt und einer Stromstufe mit einem Endwert ($I_{po}$) vergleichbar ist, der exponentiell nach der folgenden Beziehung ansteigt:

$$I_p(t) = I_{po}(1 - e^{-t/to}),$$

in der $I_{po} = E_0/R_oI$ und $t_o$ die Konstante des Kreises ist, der durch die Induktivität der Schnur ($L_o$) und dem Lastwiderstand ($R_oI$) gebildet ist, also $t_o = L_o/R_oI$, wobei die Vorbereitungsphase ferner darin besteht, den Wert der Induktivität ($L_o$) der spulenförmig gefertigten Schnur und folglich den Wert des Lastwiderstands ($R_oI$) so zu wählen, daß die Spannung (Vr(t)), die an dem Leiter erscheint, an dem die Messung durchgeführt wird, es ermöglicht, mögliche elektromagnetische Kopplungsfehler herauszustellen, wobei möglicherweise, falls dies erforderlich ist, auf die Übergangsdauer der Spannungsstufe Einfluß genommen wird, nach dem der Lastwiderstand festgelegt worden ist.

8. Verfahren nach Anspruch 7, dadurch gekennzeichnet, daß die Vorbereitungsphase darin besteht: den Ursprung der an einer entsprechenden Schnur hervorgerufenen elektromagnetischen Kopplungen zu bestimmen, indem die Schnur in ein elastisches Metallrohr (7) gesetzt wird, das an einem seiner Enden über einen Lastwiderstand ($R_I$) mit der Abschirmung (35) eines (3) der Verbinder und durch sein anderes Ende mit dem Ausgang eines Impulsgenerators (8) verbunden ist, wobei die Masse des Impulsgenerators (8) mit der Abschirmung (25) des anderen Verbinders (2) verbunden ist, wobei ein Leiter (10) des Kabels im übrigen durch jedes seiner Enden über zwei Widerstände (R1, R2) mit der Abschirmung jedes Verbinders verbunden ist, und durch Einspeisung von Spannungsstufen, die eine Übergangsflanke mit einer nicht bei Null liegenden Dauer aufweisen, den Wert des Übertragungswiderstandes ($R_o$) der entsprechenden Schnur und den Wert der Übertragungsinduktivität ($L_t$) einer entsprechenden Schnur zu bestimmen;

- die Dauer ($t_r$) der in der Testfolge zu verwendenden Vorderflanke so zu bestimmen, daß für eine entsprechende Schnur während des Übergangs keine Spannungsspitze herausgestellt wird;
- die Induktivität ($L_o$) der die Schnur bildenden Spule auszuwerten, indem die Schnur spulenförmig auf Isoliermittel (71) einer Leiterebene (70) gesetzt wird, und den Widerstandswert ($R_ol$) des Erregerkreises in Abhängigkeit von dem gemessenen Wert des Übertragungswiderstands ($R_o$), der Übertragungsinduktivität ($L_t$) und der Induktivität ($L_o$) der Spule zu bestimmen;
- und die Bezugssignatur zu suchen, indem für mehrerer Schnüre die resultierende Spannung ($V_r(t)$) erhoben wird, die zwischen dem Leiter (10) und der Abschirmung (25) eines der Verbinder erscheint, sowie ihr Mittelwert berechnet wird.

9. Verfahren nach Anspruch 8, dadurch gekennzeichnet, daß der Wert des Lastwiderstands ($R_ol$) des durch die Metallebene und die Spule gebildeten Erregerkreises ein solcher ist, daß die Zeitkonstante ($t_o$) dieses Kreises unter der Dauer des Übergangs ($t_r$) des Stroms (Ip(t)) liegt, der angelegt werden muß, wenn die Schnur nicht auf der Erregerebene liegt, sondern sich in einem koaxialen Rohr (7) befindet.

10. Verfahren nach Anspruch 9, dadurch gekennzeichnet, daß der Wert des Widerstands ($R_ol$)ein Kompromiß zwischen dem folgenden Wert: $R_ol = 10R_o.L_o/Lt$ und dem Wert der charakteristischen Impedanz der durch die Erregerebene (70) und die Abschirmung der Schnur gebildeten Einheit ist, und daß die Einstellung der Übergangsdauer bei den Testphasen dadurch durchgeführt wird, daß auf die Übergangsdauer der Spannungsstufe Eingriff genommen wird, die aus dem Spannungsgenerator (80) eingespeist wird.

11. Vorrichtung zur Durchführung des Verfahrens nach Anspruch 6, dadurch gekennzeichnet, daß sie für die Vorbereitungsphase und die Testphase identische Mittel aufweist, die einerseits durch eine Metallumhüllung (7) gebildet sind, die an einem ihrer Enden über einen Lastwiderstand ($R_l$) mit der Abschirmung eines Schnittstellengehäuses (300) verbunden ist, wobei ferner im Inneren des Gehäuses (300) über eine Verbraucherimpedanz ($Z_c$) eine Verbindung zwischen dem Ende eines Leiters (10) des Kabels und der Abschirmung des Gehäuses sichergestellt ist, wobei die Abschirmung des Gehäuses im übrigen mit der Abschirmung (35) eines der Leiter (3) der Schnur verbunden ist,

- daß die Abschirmung (25) des anderen (2) Verbinders mit einem zweiten (200) Schnittstellengehäuse verbunden ist und die Verbindung zwischen dem anderen Ende des Leiters (10) und dem Eingang eines Meßgeräts (9, 15) sicherstellt, dessen Eingangsimpedanz gleich der Verbraucherimpedanz ($Z_c$) ist, so daß die Eingangsimpedanz des Meßgeräts (9, 15) und die Lastimpedanz ($Z_c$) den Widerstand (R1) bzw. (R2) bilden, der jedes Ende des Leiters (10) mit der Abschirmung (25, 35) des entsprechenden Verbinders (2, 3) verbindet, und daß diese Abschirmung im übrigen mit dem Ausgang eines Impulsgenerators (8) verbunden ist,
- und daß das Meßgerät (9, 15) Mittel (92, 93, 94) zum Messen des Stroms ($I_p(t)$) aufweist, der in dem Erregerkreis fließt, der durch die Abschirmung der Schnur, den Lastwiderstand ($R_l$) und das Metallrohr (7) gebildet ist, sowie Mittel zum Messen der Spannung ($V_r(t)$) zwischen dem Leiter (10) und einem der Verbinder sowie Mittel zum Vergleich dieser Spannung mit einer für einen gegebenen Strom ($I_p(t)$) erhaltenen Bezugsspannung.

12. Vorrichtung zur Durchführung des Verfahrens nach Anspruch 6, dadurch gekennzeichnet, daß sie zur Bestimmung des Ursprungs der elektromagnetischen Kopplungen in einer entsprechenden Schnur und damit zur Ableitung des Übertragungswiderstands ($R_o$) einer entsprechenden Schnur sowie ihrer Übertragungsinduktivität ($L_t$) eine Vorrichtung nach Anspruch 11 aufweist, und daß sie ferner zur Beendigung der Vorbereitungsphase und zur Durchführung der Testphase eine Metallebene (70) aufweist, die mit einem Isolierschirm (71) überdeckt ist, auf den die spulenförmig gefertigten Schnüre gesetzt werden können,

- daß sie einerseits ein erstes Gehäuse (210) zur Verbindung eines Leiters (10) mit der Schnur am Eingang eines Meßgeräts (150, 900) aufweist, wobei die Abschirmung des ersten Gehäuses mit der Masse eines Generators (80) für Spannungsimpulse verbunden ist, deren Dauer der Vorderflanke ebenso wie der Wert der Stufe variabel sein kann, wobei der Ausgang des Impulsgenerators mit der Metallebene (70) verbunden ist,

- daß sie ein zweites Gehäuse (310) aufweist, das die Schnittstelle zwischen dem anderen Ende des Leiters (10) und einer Verbraucherimpedanz ($Z_c$) sicherstellt, deren Wert gleich der Eingangsimpedanz des Meßgeräts ist, so daß die Eingangsimpedanz des Meßgeräts (900, 150) und die Verbraucherimpedanz (Zc) die Widerstände (R1 bzw. R2) bilden, die jedes Ende des Leiters (10) mit der Abschirmung (25, 35) des entsprechenden Verbinders (2, 3) verbinden, wobei die Abschirmung dieses zweiten Gehäuses im übrigen über einen Lastwiderstand ($R_o$l) mit vorbestimmtem Wert mit der Metallebene (70) verbunden ist,

- und daß das Meßgerät (150, 900) Mittel (903) zum Messen des in dem Kreis fließenden Störstroms, der durch die Abschirmung der Schnur, den Lastwiderstand, die Metallebene (70) und den Generator (80) gebildet ist, sowie Mittel zum Messen der Spannung ($V_r$(t)) zwischen dem Leiter (10) und einem der Verbinder und Mittel zum Vergleich dieser Spannung mit einer für einen gegebenen Strom ($I_p$(t)) erhaltenen Bezugsspannung aufweist.

13. Vorrichtung nach Anspruch 12, dadurch gekennzeichnet, daß das Meßgerät (150, 900) und der Generator (80) mit einer Verarbeitungs- und Steuereinheit (910) verbunden sind, die es ermöglicht, den Generator (80) so zu steuern, daß ein gewünschter Störstrom ($I_p$(t)) erhalten wird.

14. Vorrichtung nach einem der Ansprüche 11 bis 13, dadurch gekennzeichnet, daß das Meßgerät (9, 15; 900, 150) einen Spannungsverstärker (15, 150) sowie ein digitales Oszilloskop (9, 900) aufweist, und daß die Mittel (94, 903) zum Messen des in dem Erregerkreis fließenden Stroms durch einen passiven, Ringtransformator gebildet sind.

15. Vorrichtung nach Anspruch 13 oder 14, dadurch gekennzeichnet, daß das Meßgerät mit einer Datenbank (911) verbunden ist, die es ermöglicht, die zur Durchführung des Tests an mehreren Typen von Schnüren erforderlichen Parameter zu messen und die Daten wieder zu aktualisieren.

**Claims**

1. A process for checking the effectiveness of the electromagnetic screening (14, 25, 35) of a connecting cord formed of two connectors (2, 3) connected by a screened cable (1) incorporating at least one conductor (10, 11, 12, 13), consisting of injecting into the screening of the cord a periodic disturbance signal and of measuring a resultant signal appearing on one (10) of the conductors of the cable in response to the passage of the disturbance signal, characterised in that the disturbance signal is a current signal ($I_p$(t)) made up of transitions between two levels (0, $I_{po}$) and the resultant signal is a voltage signal ($V_r$(t)) alternating between two corresponding levels (0, $V_o$), the value of one of the two voltage levels being a direct function of the transfer resistance ($R_o$) of the cord and of the corresponding current level, and in that the process further comprises a preparatory phase consisting of determining on a conforming type of cord the duration of the transitions of the current signal such that the resulting reference signal, called the reference signature, has a peak voltage ($V_p$) when there is an electromagnetic coupling fault ($L_t$) in the cord, while masking the acceptable electromagnetic couplings of the cord, and a test phase consisting of determining the conformity of cords of the same type by subjecting them to the same current signal and by comparing their resultant signal with the reference signature.

2. A process according to Claim 1, characterised in that the current signal is made up of current pulses that resemble trapezoids of a period T, width t1 and having transitions determined in the manner mentioned above during the preparatory phase.

3. A process according to Claim 1 or 2, characterised in that each end (101, 102) of the conductor (10) on which the measurement is made is connected to the screening of the nearest connector via a load resistor (R1, R2), such that part of the disturbance current passes through the conductor (10) and part passes through the screening (14, 25, 35) of the cord, that is, into the chain formed by the screening of the cable and of each connector.

4. A process according to Claim 3, characterised in that the load resistors (R1, R2) are identical, such that said voltage level has the value $V_o = \frac{1}{2} R_o I_{po}$ and that during the transition the peak voltage has the value $V_p = \frac{1}{2} (R_o + L_t/t_r) I_{po}$ and in that, during the preparatory phase, the duration of the transition ($t_r$) is regulated such that $t_r \gg L_t/R_o$,

which means that the peak voltage appearing during the transition nearly overlaps with the value of said voltage level ($V_o$).

5. A process according to one of Claims 1 to 4, characterised in that the preparatory phase is carried out using samples of cords conforming with the same type and the reference signal is the mean obtained from the resulting voltage signals.

6. A process according to Claim 5, characterised in that, the cords being packed in some way, the preparatory phase consists of placing the sample cords in a metal coaxial conduit (7), of connecting the end of the conduit (7) to one (3) of the connectors via a load resistor ($R_l$), the value of which is close to that of the characteristic impedance of the assembly constituted by the conduit (7) and the screening of the cord, of connecting the other (2) connector to the output of a pulse generator (8), of connecting the earth of the pulse generator (8) to the corresponding end of the metal conduit (7), of connecting on the one hand one end of the conductor (10) to the screening (35) of the connector (3), on the load resistance side ($R_l$), via a load impedance ($Z_c$), of connecting the other end of the conductor (10) to a measurement chain (9, 15), the input impedance of which is equal to the load impedance ($Z_c$) placed at the other end, such that the input impedance of the measurement chain (9, 15) and the load impedance ($Z_c$) respectively constitute the load resistors (R1, R2) connecting each end of the conductor (10) to the screening (25, 35) of the corresponding connector (2, 3), and in that it consists, after determining the duration of the necessary transition, for a given type of cord, in the same way as after determining the reference signature, of using an identical assembly for the test phase.

7. A process according to Claim 5, characterised in that, since the cords to be tested are packed in coils, the test phase consists of testing each cord by placing it on insulating means such as an insulating screen (71) covering an exciting conductor plane (70); the disturbance current ($I_p(t)$) of a given transition period ($t_r$) is obtained by connecting one of the connectors via a load resistor ($R_ol$) to the exciting conducting plane (70), by connecting the output of a voltage generator (80) to the conducting plane (70), and by connecting the earth of the generator to the screening (25) of the other connector (2); and the preparatory phase consists of acting such that, with the assembly carried out in this way, if a voltage step with a negligible transition period and a non-zero final value ($E_o$) is injected into the circuit constituted by the metal plane and the screening of the connector, then the interference current ($I_p(t)$) resulting therefrom, which circulates in the screening of the cord, is influenced by the packaging of the latter in a coil and can be compared to a current step with a final value ($I_{po}$), increasing exponentially, according to the relation:

$$I_p(t) = I_{po} (1 - e^{-t/t_o}),$$

in which $I_{po} = E_o/R_ol$, and $t_o$ is the constant of the circuit constituted by the inductance of the cord ($L_o$) and the end load resistance ($R_ol$), namely $t_o = L_o/R_ol$, the preparatory phase further consisting of determining between the inductance value ($L_o$) of the cord packed in a coil and of consequently choosing the value of the load resistor ($R_ol$), so that the voltage ($V_r(t)$), which appears on the conductor (10) on which the measurement is made, makes it possible to demonstrate any electromagnetic coupling faults by affecting, if necessary, the transition period of the voltage step after the load resistor has been fixed.

8. A process according to Claim 7, characterised in that the preparatory phase consists:
 - of determining the origin of the electromagnetic couplings caused by a conforming cord by placing the cord in a flexible metal conduit (7) connected at one of its ends, via a load resistor ($R_l$), to the screening (35) of one (3) of the connectors, and connected by its other end to the output of a pulse generator (8), the earth of the pulse generator being connected to the screening (25) of the other connector (2), one conductor (10) of the cable further being connected, by each of its ends, via two resistors (R1, R2), to the screening of each of the connectors, and of determining, by injecting transition front voltage steps with a non-zero duration, the value of the transfer resistor ($R_o$) of the conforming cord and the transfer inductance value ($L_t$) of a conforming cord;
 - of determining the duration ($t_r$) of the rising edge that has to be used in the rest of the test such that, for a conforming cord, no voltage peak is demonstrated during the transition;
 - of evaluating the inductance ($L_o$) of the coil composing the cord, by placing it in a coil on the insulating means (71) of a conducting plane (70), and of determining the resistance value ($R_ol$) of the exciting circuit, as a function of the measured value for transfer resistance ($R_o$), for transfer inductance ($L_t$) and for the inductance of the coil ($L_o$);
 - and of looking for the reference signature by recording, for several cords, the resulting voltage ($V_r(t)$) appearing between the conductor (10) and the screening (25) of one of the connectors and by calculating the mean value.

9. A process according to Claim 8, characterised in that the value of the load resistance ($R_0$l) of the exciting circuit constituted by the metal plane and the coil is such that the time constant ($t_0$) of this circuit is less than the transition period ($t_r$) of the current ($I_p(t)$) that has to be applied when the cord, instead of being placed on the exciting plane, is in a coaxial tube (7).

10. A process according to Claim 9, characterised in that the value of the resistance ($R_0$l) is a compromise between the following value: $R_0l = 10R_0.L_0/L_t$ and the value of the characteristic impedance of the assembly constituted by the exciting plane (70) and the screening of the cord, and in that the transition period at the time of the test phases is adjusted by acting on the transition period of the voltage step injected from the voltage generator (80).

11. A device for implementing the process according to Claim 6, characterised
    - in that it comprises, for the preparatory phase and for the test phase, identical means, constituted on the one hand by a metal envelope (7), connected at one of its ends to the screening of an interface module (300), via a load resistor ($R_l$), a connection further being provided inside the module (300) between the end of a conductor (10) of the cable and the screening of said module via a load impedance ($Z_c$), the screening of the module being further connected to the screening (35) of one of the connectors (3) of the cord,
    - in that the screening (25) of the other (2) connector is linked to a second (200) interface module, and provides the connection between the other end of the conductor (10) and the input of a measurement chain (9, 15), the input impedance of which is equal to the load impedance ($Z_c$), such that the input impedance of the measurement chain (9, 15) and the load impedance ($Z_c$) respectively constitute the resistors (R1, R2) connecting each end of the conductor (10) to the screening (25, 35) of the corresponding connector (2, 3), and in that this screening is further connected to the output of a pulse generator (8),
    - and in that the measurement chain (9, 15) comprises means (92, 93, 94) for measuring the current ($I_p(t)$) circulating in the exciting circuit constituted by the screening of the cord, the load resistor ($R_1$) and the metal

tube (7), and means for measuring the voltage ($V_r(t)$) between the conductor (10) and one of the connectors and means for comparing this voltage with a reference voltage obtained for a given current ($I_p(t)$).

12. A device for implementing the process according to Claim 6, characterised
    - in that, for determining in a conforming cord the origin of the electromagnetic couplings, and thus deducing therefrom the transfer resistance ($R_0$) of a conforming cord and its transfer inductance ($L_t$), it comprises a device according to Claim 11, and in that, for ending the preparatory phase and carrying out the test phase, it further comprises a metal plane (70) covered with an insulating screen (71), on which the cords packed in coils can be placed,
    - in that it comprises a first module (210) for connecting a conductor (10) to the cord at the input to a measurement chain (150, 900) on the one hand, the screening of which first module is connected to the earth of a voltage pulse generator (80), the duration of the rising edge of which can be variable, as can the value of the level, the output of the pulse generator being connected to the metal plane (70),
    - in that it comprises a second module (310) providing the interface between the other end of the conductor (10) and a load impedance ($Z_c$), the value of which is equal to that of the input impedance of the measurement chain, such that the input impedance of the measurement chain (900, 150) and the load impedance ($Z_c$) constitute respectively the resistors (R1, R2) connecting each end of the conductor (10) to the screening (25, 35) of the corresponding connector (2, 3), the screening of this second module being further connected to the metal plane (70) via a load resistor ($R_0$l) of a predetermined value,
    - in that the measurement system (150, 900) comprises means (903) for measuring the disturbance current circulating through the circuit constituted by the screening of the cord, the load resistor, the metal plane (70) and the generator (80), and means for measuring the voltage ($V_r(t)$) between the conductor (10) and one of the connectors and means for comparing this voltage to a reference voltage obtained for a given current ($I_p(t)$).

13. A device according to Claim 12, characterised in that the measurement chain (150, 900) and the generator (80) are connected to a processing and control unit (910) making it possible to drive the generator (80) in order to obtain an disturbance current ($I_p(t)$) as desired.

14. A device according to one of Claims 11 to 13, characterised in that the measurement chain (9, 15; 900, 150) comprises a voltage amplifier (15, 150), and a digital oscilloscope (9, 900), and in that the means (94, 903) for measuring the current circulating in the exciting circuit are constituted by a passive toroidal transformer.

15. A device according to Claim 13 or 14, characterised in that the measurement chain is connected to a data bank (911) making it possible to measure the parameters necessary for carrying out the test on several types of cords, and to update said data.

# FIG.1

# FIG.2

GENERATEUR

# FIG.3

FIG.4

FIG.5

FIG.6A

FIG.6B

## FIG.7A

## FIG.7B

## FIG.8A

## FIG.8B

## FIG.9

## FIG.10

## FIG.11

$E_o(t)$

$E_o$ ------ (1)

$t$

$I_p(t)$

$I_{po}$ ------ (2)

$t$

## FIG.12

$E_o(t)$

$E_o$ ------ (1)

$t$

$I_p(t)$

$I_{po}$ ------ (2)

$t_{do}$

$t$

# FIG. 13